(19) **Europäisches Patentamt / European Patent Office / Office européen des brevets**

(11) **EP 3 539 126 B1**

(12) **EUROPEAN PATENT SPECIFICATION**

(45) Date of publication and mention of the grant of the patent:
**30.09.2020 Bulletin 2020/40**

(21) Application number: **17791415.7**

(22) Date of filing: **30.10.2017**

(51) Int Cl.:
*G10L 19/008* (2013.01)     *H04S 3/00* (2006.01)

(86) International application number:
**PCT/EP2017/077824**

(87) International publication number:
**WO 2018/086948 (17.05.2018 Gazette 2018/20)**

(54) **APPARATUS AND METHOD FOR DOWNMIXING OR UPMIXING A MULTICHANNEL SIGNAL USING PHASE COMPENSATION**

VORRICHTUNG UND VERFAHREN ZUM HERUNTERMISCHEN ODER HOCHMISCHEN EINES MEHRKANALSIGNALS UNTER VERWENDUNG VON PHASENKOMPENSATION

APPAREIL ET PROCÉDÉ DE SOUS-MIXAGE OU DE MIXAGE ÉLÉVATEUR D'UN SIGNAL MULTIPLEX À L'AIDE D'UNE COMPENSATION DE PHASE

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **08.11.2016 EP 16197816**

(43) Date of publication of application:
**18.09.2019 Bulletin 2019/38**

(60) Divisional application:
**20190710.2**

(73) Proprietor: **Fraunhofer-Gesellschaft zur Förderung der angewandten Forschung e.V.**
**80686 München (DE)**

(72) Inventors:
- **BUETHE, Jan**
  **91054 Erlangen (DE)**
- **FUCHS, Guillaume**
  **91088 Bubenreuth (DE)**
- **JAEGERS, Wolfgang**
  **91056 Erlangen (DE)**
- **REUTELHUBER, Franz**
  **91056 Erlangen (DE)**
- **HERRE, Juergen**
  **91054 Erlangen (DE)**
- **FOTOPOULOU, Eleni**
  **90409 Nürnberg (DE)**
- **MULTRUS, Markus**
  **90469 Nürnberg (DE)**
- **KORSE, Srikanth**
  **90408 Nürnberg (DE)**

(74) Representative: **Zinkler, Franz et al**
**Schoppe, Zimmermann, Stöckeler Zinkler, Schenk & Partner mbB Patentanwälte Radlkoferstrasse 2 81373 München (DE)**

(56) References cited:
**WO-A1-2010/097748     US-A1- 2008 253 576 US-B2- 9 269 361**

- **SAMSUDIN ET AL: "A Stereo to Mono Dowmixing Scheme for MPEG-4 Parametric Stereo Encoder", ACOUSTICS, SPEECH AND SIGNAL PROCESSING, 2006. ICASSP 2006 PROCEEDINGS . 2006 IEEE INTERNATIONAL CONFERENCE ON TOULOUSE, FRANCE 14-19 MAY 2006, PISCATAWAY, NJ, USA,IEEE, PISCATAWAY, NJ, USA, 14 May 2006 (2006-05-14), page V, XP031387161, DOI: 10.1109/ICASSP.2006.1661329 ISBN: 978-1-4244-0469-8**

**Description**

Specification

The present invention relates to the field of audio encoding and, particularly, to the field of stereo or multichannel encoding/decoding.

The state of the art methods for lossy parametric encoding of stereo signals at low bitrates are based on parametric stereo as standardized in MPEG-4 Part 3. The general idea is to reduce the number of channels by computing a downmix signal from two input channels after extracting stereo parameters which are sent as side information to the decoder. These stereo parameters are usually inter-channel-level-difference ILD, inter-channel-phase-difference IPD, and inter-channel-coherence ICC, which are calculated in subbands and which capture the spatial image to a certain extent.

The decoder performs an upmix of the mono input, creating two channels satisfying the ILD, IPD and ICC relations. This is done by matrixing the input signal together with a decorrelated version of that signal which is generated at the decoder. An example of encoding and decoding an audio signal using downmixing and upmixing can be found in US 2008/0253576 A1.

It has been found that e.g. the usage of such parameters incurs a significant complexity for calculating and handling these parameters. Particularly, the ILD parameter is problematic, since it can have values that are very small or very big and this almost unrestricted range of values raises problems with respect to an efficient calculation, quantization etc.

It is an object of the present invention to provide an improved concept for processing multichannel data.

This object is achieved by an apparatus for downmixing a multichannel signal in accordance with claim 1, an apparatus for upmixing an encoded multichannel signal in accordance with claim 17, a method of downmixing a multichannel signal of claim 33, a method of upmixing an encoded multichannel signal of claim 34, or a computer program of claim 35.

The present invention of a first aspect is based on the finding that, in contrast to the prior art, a different parametric encoding procedure is adopted that relies on two gain parameters, i.e., a side gain parameter and a residual gain parameter. Both gain parameters are calculated from a first channel of at least two channels of a multichannel signal and a second channel of the at least two channels of the multichannel signal. Both of these gain parameters, i.e., the side gain and the residual gain are transmitted or stored or, generally output together with a downmix signal that is calculated from the multichannel signal by a downmixer.

Embodiments of the present invention of the first aspect are based on a new mid/side approach, leading to a new set of parameters: at the encoder a mid/side transformation is applied to the input channels, which together capture the full information of two input channels. The mid signal is a weighted mean value of left and right channel, where the weights are complex and chosen to compensate for phase differences. Accordingly, the side signal is the corresponding weighted difference of the input channels. Only the mid signal is waveform coded while the side signal is modelled parametrically. The encoder operates in subbands where it extracts IPDs and two gain parameters as stereo parameter. The first gain, which will be referred to as the side gain, results from a prediction of the side signal by the mid signal and the second gain, which will be referred to as residual gain, captures the energy of the remainder relative to the energy of the mid signal. The mid signal then serves as a downmix signal, which is transmitted alongside the stereo parameters to the decoder.

The decoder synthesizes two channels by estimating the lost side channel based on the side gain and the residual gain and using a substitute for the remainder.

The present invention of the first aspect is advantageous in that the side gain on the one hand and the residual gain on the other hand are gains that are limited to a certain small range of numbers. Particularly, the side gain is, in preferred embodiments, limited to a range of -1 to +1, and the residual gain is even limited to a range of 0 and 1. And, what is even more useful in a preferred embodiment is that the residual gain depends on the side gain so that the range of values that the residual gain can have is becoming the smaller the bigger the side gain becomes.

Particularly, the side gain is calculated as a side prediction gain that is applicable to a mid signal of the first and the second channel in order to predict a side signal of the first and second channels. And the parameter calculator is also configured to calculate the residual gain as a residual prediction gain indicating an energy of or an amplitude of a residual signal of such a prediction of the side signal by the mid signal and the side gain.

Importantly, however, it is not necessary to actually perform the prediction on the encoder side or to actually encode the side signal on the encoder side. Instead, the side gain and the residual gain can be calculated by only using amplitude related measures such as energies, powers, or other characteristics related to the amplitudes of the left and the right channel. Additionally, the calculation of the side gain and the residual gain is only related to the inner product between both channels, i.e., any other channels apart from the left channel and the right channel, such as the downmix channel itself or the side channel itself are not necessary to be calculated in embodiments. However, in other embodiments, the side signal can be calculated, different trials for predictions can be calculated and the gain parameters such as the side gain and the residual gain can be calculated from a residual signal that is associated with a certain side gain prediction resulting in a predefined criterion in the different trials such as a minimum energy of the residual or remainder signal. Thus, there exists high flexibility and, nevertheless, low complexity for calculating the side gain on the one hand and the residual gain on the other hand.

There are exemplary two advantages of the gain parameters over ILD and ICC. First, they naturally lie in finite intervals (the side gain in [-1,1] and the residual gain in [0,1]) as opposed to the ILD parameter, which may take arbitrary large or small values. And second, the calculation is less complex, since it only involves a single special function evaluation, whereas the calculation of ILD and ICC involves two.

Preferred embodiments of the first aspect rely on the calculation of the parameters in the spectral domain, i.e., the parameters are calculated for different frequency bins or, more preferably, for different subbands where each subband comprises a certain number of frequency bins. In a preferred embodiment, the number of frequency bins included within a subband increases from lower to higher subbands in order to mimic the characteristic of the human listening perception, i.e., that higher bands cover higher frequency ranges or bandwidths and lower bands cover lower frequency ranges or bandwidths.

In a preferred embodiment, the downmixer calculates an absolute phase compensated downmix signal where, based on an IPD parameter, phase rotations are applied to the left and to the right channel, but the phase compensation is performed in such a way that the channel having more energy is less rotated than the channel having less energy. For controlling the phase compensation, the side gain can preferably be used, however, in other embodiments, any other downmix can be used, and this is also a specific advantage of the present invention that the parametric representation of the side signal, i.e., the side gain on the one hand and the residual gain on the other hand are calculated only based on the original first and second channels, and any information on a transmitted downmix is not required. Thus, any downmix can be used together with the new parametric representation consisting of the side gain and the residual gain, but the present invention is also particularly useful for being applied together with an absolute phase compensation that is based on the side gain.

In a further embodiment of the absolute phase compensation, the phase compensation parameter is particularly calculated based on a specific predetermined number so that the singularity of the arctangent function (atan or $\tan^{-1}$) that occurs in calculating the phase compensation parameter is moved from the center to a certain side position. This shifting of the singularity makes sure that any problems due the singularity do not occur for phase shifts of +/- 180° and a gain parameter close to 0, i.e., left and right channels that have quite similar energies. Such signals have been found to occur quite often, but signals being out of phase with each other but having a difference, for example, between 3 and 12 dB or around 6 dB do not occur in natural situations. Thus, although the singularities is only shifted, it has been found that this shifting nevertheless improves the overall performance of the downmixer, since this shifting makes sure that the singularity occurs at a signal constellation situation that occurs, in normal situations, much less than where the straightforward arctangent function has its singularity point.

Further embodiments make use of the dependency of the side gain and the residual gain for implementing an efficient quantization procedure. To this end, it is preferred to perform a joint quantization that, in a first embodiment, is performed so that the side gain is quantized first and, then the residual gain is quantized using quantization steps that are based on the value of the side gain. However, other embodiments rely on a joint quantization, where both parameters are quantized into a single code, and certain portions of this code rely on certain groups of quantization points that belong to a certain level difference characteristic of the two channels that are encoded by the encoder.

A second aspect relates to an apparatus for downmixing a multi-channel signal comprising at least two channels, the apparatus comprising: a downmixer for calculating a downmix signal from the multi-channel signal, wherein the downmixer is configured to calculate the downmix using an absolute phase compensation, so that a channel having a lower energy among the at least two channels is only rotated or is rotated stronger than a channel having a greater energy in calculating the downmix signal; and an output interface for generating an output signal, the output signal comprising information on the downmix signal.

Preferably the rotation is carried out preferably on the minor channel, but the case can be in small energy difference situations that the minor channel is not always rotated more than the major channel, But, if the energy ratio is sufficiently large or sufficiently small, then the preferred embodiment rotates the minor channel more than the major channel. Thus, preferably, the minor channel is rotated more than the major channel only when the energy difference is significant or is more than a predefined threshold such as 1 dB or more. This applies not only for the downmixer but also for the upmixer.

Preferred embodiments of the present invention are subsequently discussed with respect to the attached drawings, in which:

Fig. 1        is a block diagram of an apparatus for encoding a multichannel signal of an embodiment;

Fig. 2      is a block diagram of an embodiment of the parameter calculator;

Fig. 3      is a further embodiment of the parameter calculator;

Fig. 4      is an embodiment of a downmixer performing an absolute phase compensation;

Fig. 5a      is a block diagram of an embodiment of the output interface performing a specific quantization;

Fig. 5b      indicates an exemplary codeword;

Fig. 6      is an embodiment of an apparatus for decoding an encoded multichannel signal;

Fig. 7      is an embodiment of the upmixer;

Fig. 8      is an embodiment of the residual signal synthesizer;

Fig. 9      is an embodiment for the input interface;

Fig. 10a      illustrates the processing of overlapping frames;

Fig. 10b      illustrates an embodiment of the time-spectrum converter;

Fig. 10c      illustrates a spectrum of a left channel or a right channel and a construction of different subbands;

Fig. 10d      illustrates an embodiment for a spectrum-time converter;

Fig. 11      illustrates lines for a conditional quantization in a first embodiment;

Fig. 12      illustrates lines for a joint quantization in accordance with a further embodiment; and

Fig. 13      illustrates joint quantization points for the side gain and the residual gain.

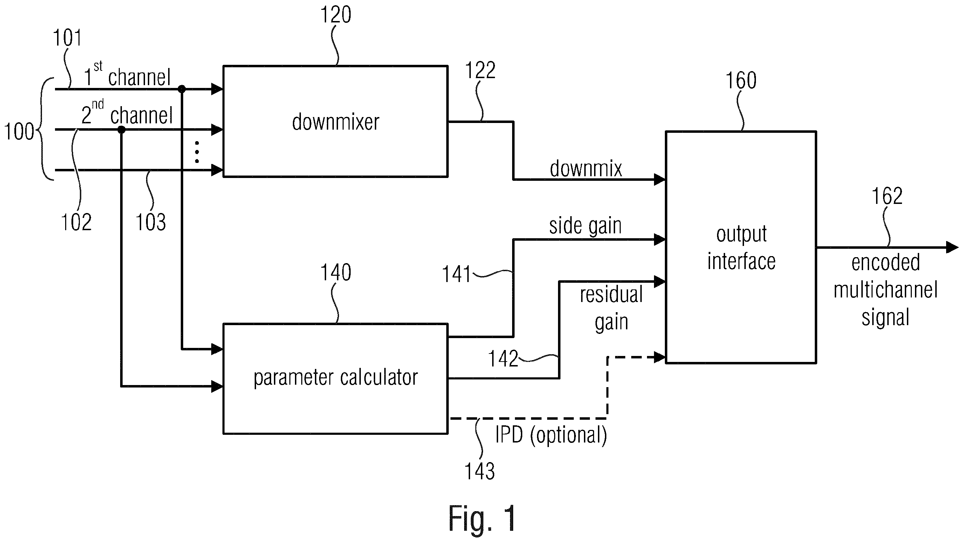

Fig. 1 illustrates an apparatus for encoding a multichannel signal comprising at least two channels. Particularly, the multichannel signal is illustrated at 100 in Fig. 1 and has a first channel 101 and a second channel 102 and no additional channels or an arbitrarily selected number of additional channels where a further additional channel is illustrated at 103.

The multichannel signal 100 is input into a downmixer 120 for calculating a downmix signal 122 from the multichannel signal 100. The downmixer can use, for calculating the multichannel signal, the first channel 101, the second channel 102 and the third channel 103 or only the first and the second channel or all channels of the multichannel signal depending on the certain implementation.

Furthermore, the apparatus for encoding comprises a parameter calculator 140 for calculating a side gain 141 from the first channel 101 and the second channel 102 of the at least two channels and, additionally, the parameter calculator 104 calculates a residual gain 142 from the first channel and the second channel. In other embodiments, an optional inter-channel phase difference (IPD) is also calculated as illustrated at 143. The downmix signal 122, the side gain 141 and the residual gain 142 are forwarded to an output interface 160 that generates an encoded multichannel signal 162 that comprises information on the downmix signal 122, on the side gain 141 and the residual gain 142.

It is to be noted that the side gain and the residual gain are typically calculated for frames so that, for each frame, a single side gain and the single residual gain is calculated. In other embodiments, however, not only a single side gain and a single residual gain is calculated for each frame, but a group of side gains and the group of residual gains are calculated for a frame where each side gain and each residual gain are related to a certain subband of the first channel and the second channel. Thus, in preferred embodiments, the parameter calculator calculates, for each frame of the first and the second channel, a group of side gains and a group of residual gains, where the number of the side and the residual gains for a frame is typically equal to the number of subbands. When a high resolution time-spectrum-conversion is applied such as a DFT, the side gain and the residual gain for a certain subband are calculated from a group of frequency bins of the first channel and the second channel. However, when a low resolution time-frequency transform is applied that results in subband signals, then the parameter calculator 140 calculates, for each subband or even for a group of subbands a side gain and a residual gain.

When the side gain and the residual gain are calculated for a group of subband signals, then the parameter resolution is reduced resulting in a lower bitrate but also resulting in a lower quality representation of the parametric representation of the side signal. In other embodiments, the time resolution can also be modified so that a side gain and a residual gain are not calculated for each frame but are calculated for a group of frames, where the group of frames has two or more frames. Thus, in such an embodiment, it is preferred to calculate subband-related side/residual gains, where the side/residual gains refer to a certain subband, but refer to a group of frames comprising two or more frames. Thus, in accordance with the present invention, the time and frequency resolution of the parameter calculation performed by block 140 can be modified with high flexibility.

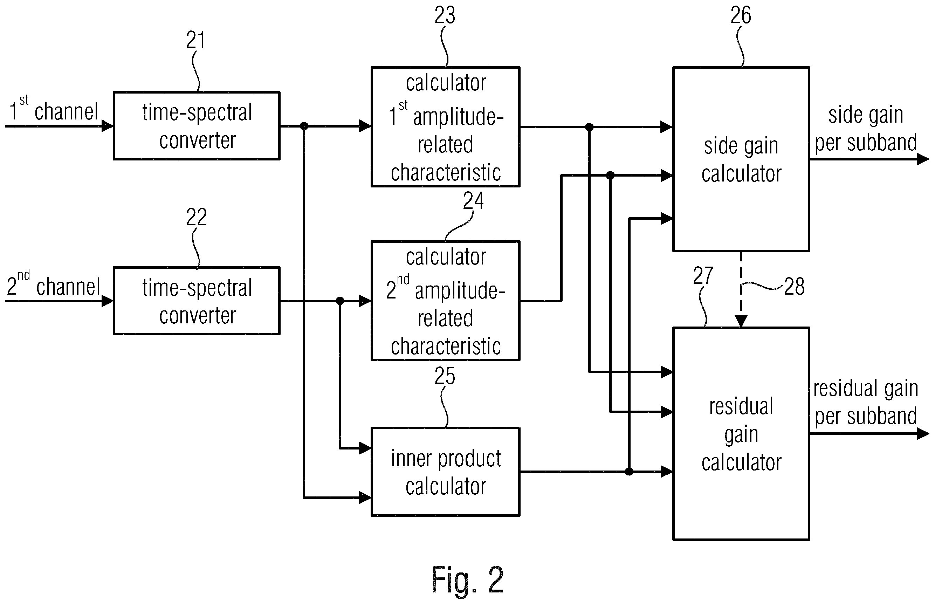

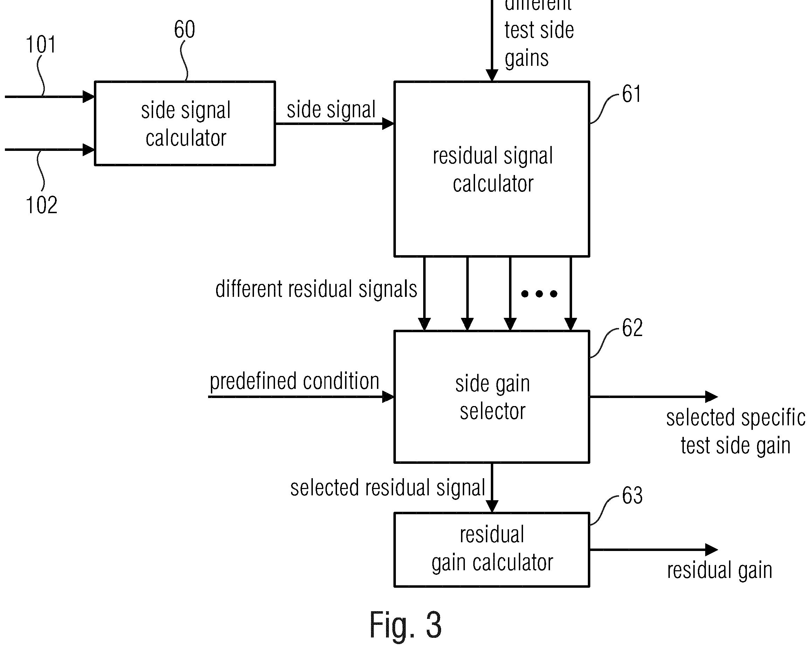

The parameter calculator 140 is preferably implemented as outlined in Fig. 2 with respect to a first embodiment or as outlined in Fig. 3 with respect to a second embodiment. In the Fig. 2 embodiment, the parameter calculator comprises a first time-spectral converter 21 and a second time-spectral converter 22. Furthermore, the parameter calculator 140 of Fig. 1 comprises a calculator 23 for calculating a first amplitude-related characteristic and a calculator 24 for calculating a second amplitude-related characteristic and a calculator 25 for calculating an inner product of the output of blocks 21 and 22, i.e., of the spectral representation of the first and second channels.

The outputs of blocks 23, 24, 25 are forwarded to a side gain calculator 26 and are also forwarded to a residual gain calculator 27. The side gain calculator 26 and the residual gain calculator 27 apply a certain relation among the first amplitude related characteristic, the second amplitude related characteristic and the inner product and the relation applied by the residual gain calculator for combining both inputs is different from the relation that is applied by the side gain calculator 26.

In a preferred embodiment, the first and the second amplitude related characteristics are energies in subbands. However, other amplitude related characteristics relate to the amplitudes in subbands themselves, relate to signal powers in subbands or relate to any other powers of amplitudes with an exponent greater than 1, where the exponent can be a real number greater than 1 or an integer number greater than 1 such an integer number of 2 relating to a signal power and an energy or relating to an number of 3 that is associated with loudness, etc. Thus, each amplitude-related characteristic can be used for calculating the side gain and the residual gain.

In a preferred embodiment, the side gain calculator and the residual gain calculator 27 are configured to calculate the side gain as a side prediction gain that is applicable to a mid-signal of the first and the second channels to predict a side signal of the first and the second channels or the parameter calculator and, particularly, the residual gain calculator 27 is configured to calculate the residual gain as a residual prediction gain indicating an amplitude related measure of a residual signal of a prediction of the side signal by the mid-signal using the side gain.

In particular, the parameter calculator 140 and the side gain calculator 26 of Fig. 2 is configured to calculate the side signal using a fraction having a nominator and a denominator, wherein the nominator comprises amplitude characteristics of the first and the second channel and the denominator comprises the amplitude characteristic of the first and the second channels and a value derived from the inner product. The value derived from the inner product is preferably the absolute value of the inner product but can alternatively be any power of the absolute value such as a power greater than 1, or can even be a characteristic different from the absolute value such as a conjugate complex term or the inner product itself or so on.

In a further embodiment, the parameter calculator the residual gain calculator 27 of Fig. 2 also uses a fraction having a nominator and a denominator both using a value derived from the inner product and, additionally, other parameters. Again, the value derived from the inner product is preferably the absolute value of the inner product but can alternatively be any power of the absolute value such as a power greater than 1, or can even be a characteristic different from the absolute value such as a conjugate complex term or the inner product itself or so on.

In particular, the side calculator 26 of Fig. 2 is configured to use, for calculating the side gain, the difference of energies of the first channels and the denominator uses a sum of the energies or amplitude characteristics of both channels and, additionally, an inner product and preferably two times the inner product but other multipliers for the inner product can also be used.

The residual gain calculator 27 is configured for using, in the nominator, a weighted sum of the amplitude characteristics of the first and the second channels and an inner product where the inner product is subtracted from the weighted sum of the amplitude characteristics of the first and the second channels. The denominator for calculating the residual gain calculator comprises a sum of the amplitude characteristics of the first and the second channel and the inner product where the inner product is preferably multiplied by two but can be multiplied by other factors as well.

Furthermore, as illustrated by the connection line 28, the residual gain calculator 27 is configured for calculating the residual gain using the side gain calculated by the side gain calculator.

In a preferred embodiment, the residual gain and the side gain operate as follows. In particular, the bandwise inter-channel phase differences that will be described later on can be calculated or not. However, before particularly outlining the calculation of the side gain as illustrated later on in equation (9) and the specific preferred calculation of the side gain as illustrated later on in equation (10), a further description of the encoder is given that also refers to a calculation of IPDs and downmixing in addition to the calculation of the gain parameters.

Encoding of stereo parameters and computation of the downmix signal is done in frequency domain. To this end, time frequency vectors $L_t$ and $R_t$ of the left and right channel are generated by simultaneously applying an analysis window followed by a discrete Fourier transform (DFT): The DFT bins are then grouped into subbands $(L_t,k)_k \in I_b$ resp. $(R_t,k)_k \in I_b$, where $I_b$ denotes the set of subbands indices.

Calculation of IPDs and Downmixing

For the downmix, a bandwise inter-channel-phase-difference (IPD) is calculated as

$$IPD_{t,b} = \arg(\sum_{k \in I_b} L_{t,k} R_{t,k}^*)$$

$$(1)$$

where $z^*$ denotes the complex conjugate of $z$. This is used to generate a bandwise mid and side signal

$$M_{t,k} = \frac{e^{-i\beta}L_{t,k} + e^{i(IPD_{t,b}-\beta)}R_{t,k}}{\sqrt{2}}$$

$$(2)$$

and

$$S_{t,k} = \frac{e^{-i\beta}L_{t,k} + e^{i(IPD_{t,b}-\beta)}R_{t,k}}{\sqrt{2}}$$

$$(3)$$

for $k \in I_b$. The absolute phase rotation parameter $\beta$ is given by

$$\beta = atan2(\sin(IPD_{t,b}), \cos(IPD_{t,b}) + 2\frac{1+g_{t,b}}{1-g_{t,b}})$$

$$(4)$$

where $g_{t,b}$ denotes the side gain which will be specified below. Here, atan2(y,x) is the two argument arctangent function whose value is the angle between the point $(x,y)$ and the positive $x$-axis. It is intended to carry out the IPD compensation rather on the channel which has less energy. The factor 2 moves the singularity at $IPD_{t,b} = \pm\pi$ and $g_{t,b} = 0$ to $IPD_{t,b} = \pm\pi$ and $g_{t,b} = -1/3$. This way toggling of $\beta$ is avoided in out-of-phase situations with approximately equal energy distribution in left and right channel. The downmix signal is generated by applying the inverse DFT to $M_t$ followed by a synthesis window and overlap add.

In other embodiments, other arctangent functions different from atan2-function can be used as well such as a straightforward tangent function, but the atan2 function is preferred due to its safe application to the posed problem.

Calculation of gain parameters

Additional to the band-wise IPDs, two further stereo parameters are extracted. The optimal gain for predicting $S_{t,b}$ by $M_{t,b}$, i.e. the number $g_{t,b}$ such that the energy of the remainder

$$p_{t,k} = S_{t,k} - g_{t,b}M_{t,k}$$

$$(5)$$

is minimal, and a gain factor $r_{t,b}$ which, if applied to the mid signal $M_t$, equalizes the energy of $p_t$ and $M_t$ in each band, i.e.

$$r_{t,b} = \sqrt{\frac{\Sigma_{k\in l_b}|\,p_{t,k}\,|^2}{\Sigma_{k\in l_b}|\,M_{t,k}\,|^2}}$$

$$(6)$$

The optimal prediction gain can be calculated from the energies in the subbands

$$E_{L,t,b} = \sum_{k\in l_b}|\,L_{t,k}|^2 \quad \text{and} \quad E_{R,t,b} = \sum_{k\in l_b}|R_{t,k}|^2$$

$$(7)$$

and the absolute value of the inner product of $L_t$ and $R_t$

$$X_{L/R,t,b} = |\sum_{k\in l_b} L_{t,k}R_{t,k}^*|$$

$$(8)$$

as

$$g_{t,b} = \frac{E_{L,t,b} - E_{R,t,b}}{E_{L,t,b} + E_{R,t,b} + 2X_{L/R,t,b}}$$

$$(9)$$

From this it follows that $g_{t,b}$ lies in [-1,1]. The residual gain can be calculated similarly from the energies and the inner product as

$$r_{t,b} = \left(\frac{\left(1-g_{t,b}\right)E_{L,t,b}+\left(1+g_{t,b}\right)E_{R,t,b}-2X_{L/R,t,b}}{E_{L,t,b}+E_{R,t,b}+2X_{L/R,t,b}}\right)^{1/2}$$

$$(10)$$

which implies

$$0 \leq r_{t,b} \leq \sqrt{1 - g_{t,b}^2}$$

$$(11)$$

In particular, this shows that $r_{t,b} \in [0,1]$. This way, the stereo parameters can be calculated independently from the downmix by calculating the corresponding energies and the inner product. In particular, it is not necessary to compute the residual $p_{t,k}$ in order to compute its energy. It is noteworthy that calculation of the gains involves only one special function evaluation whereas calculation of ILD and ICC from $E_{L,t,b}$, $E_{R,t,b}$ and $X_{L/R,t,b}$ involves two, namely a square root and a logarithm:

$$\text{ILD}_{t,b} = 10log_{10}\left(\frac{E_{L,t,b}}{E_{R,t,b}}\right)$$

$$(12)$$

and

$$ICC_{t,b} = \frac{X_{L/R,t,b}}{\sqrt{E_{L,t,b} \cdot E_{R,t,b}}}$$

$$(13)$$

Lowering Parameter Resolution

If a lower parameter resolution as given by the window length is desired, one may compute the gain parameters over $h$ consecutive windows by replacing $X_{L/R,t,b}$ by

$$X_{L/R,t,b} = \sum_{s=t}^{t+h} X_{L/R,r,b}$$

$$(14)$$

and $E_{L,t,b}$ resp. $E_{R,t,b}$ by

$$\varepsilon_{L/R,t,b} = \sum_{s=t}^{t+h} E_{L/R,r,b}$$

$$(15)$$

in (9) and (10). The side gain is then a weighted average of the side gains for the individual windows where the weights depend on the energy of $M_{t+i,k}$ or depends on the bandwise energies $E_{M,s,b}$, wherein s is the summation index in equations 14 and 15.

Similarly, the IPD values are then calculated over several windows as

$$IPD_{t,b} = \arg\left( \sum_{t=t}^{t+h} \sum_{k \in l_b} L_{t,k}\, R_{t,k}^* \right)$$

$$(16)$$

Preferably, the parameter calculator 140 illustrated in Fig. 1 is configured to calculate the subband-wise representation as a sequence of complex valued spectra, where each spectrum is related to a time frame of the first channel or the second channel, where the time frames of the sequence are adjacent to each other and where adjacent time frames overlap with each other.

Furthermore, the parameter generator 140 is configured to calculate the first and the second amplitude related measures by squaring magnitudes of complex spectral values in a subband and by summing squared magnitudes in the subband as, for example, also previously illustrated in equation (7), where index b stands for the subband.

Furthermore, as also outlined in equation 8, the parameter calculator 140 and, in particular, the inner product calculator 25 of Fig. 2 is configured to calculate the inner product by summing, in a subband, the products, wherein each product involves a spectral value in a frequency bin of the first channel and a conjugate complex spectral value of the second channel for the frequency bin. Subsequently, a magnitude of a result of the summing together is formed.

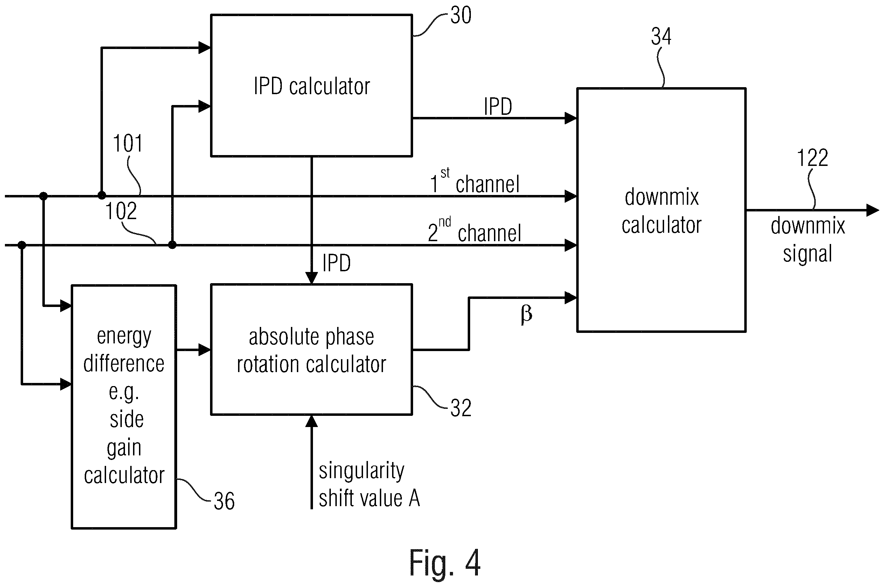

As also outlined in equations 1 to 4, it is preferred to use an absolute phase compensation. Thus, in this embodiment, the downmixer 120 is configured to calculate the downmix 122 using an absolute phase compensation so that only the channel having the lower energy among the two channels is rotated or the channel having the lower energy among the two channels is rotated stronger than the other channel that has a greater energy when calculating the downmix signal. Such a downmixer 120 is illustrated in Fig. 4. In particular, the downmixer comprises an inter-channel phase difference (IPD) calculator 30, an absolute phase rotation calculator 32, a downmix calculator 34 and an energy difference or side gain calculator 36. It is to be emphasized that the energy difference or side gain calculator 36 can be implemented as the side gain calculator 26 in Fig. 2. Alternatively, however, for the purpose of phase rotation, there can also be a different implementation in block 36 that only calculates an energy difference or, in general, an amplitude related characteristic difference that can be the energy, the power or the amplitudes themselves or powers of the amplitudes that are added together where a power is different from two such as a power between one and two or greater than two.

In particular, an exponent or power of three corresponds, for example, to the loudness rather than to the energy.

In particular, the IPD calculator 30 of Fig. 4 is configured to calculate an inter-channel phase difference typically for each subband of a plurality of subbands of each of the first and the second channels 101, 102 input into block 30. Furthermore, the downmixer has the absolute phase rotation parameter, again typically for each subband of the plurality of subbands that operates based on an energy difference provided by block 36 between the first and the second channel or, in general, based on an amplitude-related characteristic difference between both channels 101, 102. Additionally, the downmix calculator 34 is configured to weight, when calculating the downmix signal, the first and the second channels using the IPD parameters and the absolute phase rotation parameters indicated as $\beta$.

Preferably, block 36 is implemented as a side gain calculator so that the absolute phase rotation calculator operates based on the side gain.

Thus, block 30 of Fig. 4 is configured for implementing equation (1), block 32 is configured for implementing equation (4) and block 34 is configured for implementing equation (2) in a preferred embodiment.

In particular, the factor 2 in equation (4) before the term involving the side gain $g_{t,b}$ can be set different from 2 and can be, for example, a value preferably between 0.1 and 100. Naturally, also -0.1 and -100 can also be used. This value makes sure that the singularity existing at an IPD of +-180° for almost equal left and right channels is moved to a different place, i.e., to a different side gain of, for example, -1/3 for the factor 2. However, other factors different from 2 can be used. These other factors then move the singularity to a different side gain parameter from -1/3. It has been shown that all these different factors are useful since these factors achieve that the problematic singularity is at a "place" in the sound stage having associated left and right channel signals that typically occur less frequently than signals being out of phase and having equal or almost equal energy.

In the preferred embodiment, the output interface 160 of Fig. 1 is configured for performing a quantization of the parametric information, i.e., a quantization of the side gain as provided on line 141 by the parameter calculator 140 and the residual gain as provided on line 142 from the parameter calculator 140 of Fig. 1.

Particularly in the embodiment, where the residual gain depends on the side gain, if it is preferred to quantize the side gain and to then quantize the residual gain, wherein, in this embodiment, the quantization step for the residual gain depends on the value of the side gain.

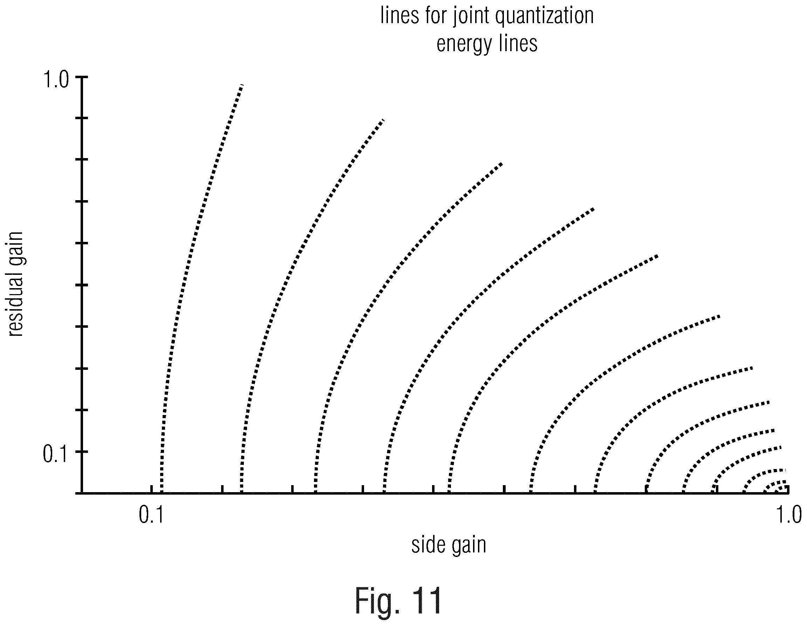

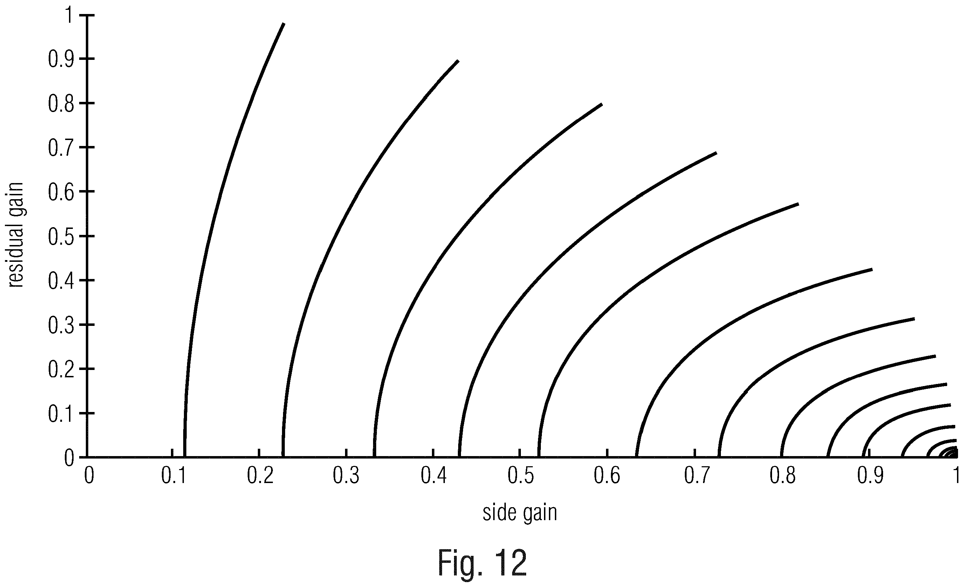

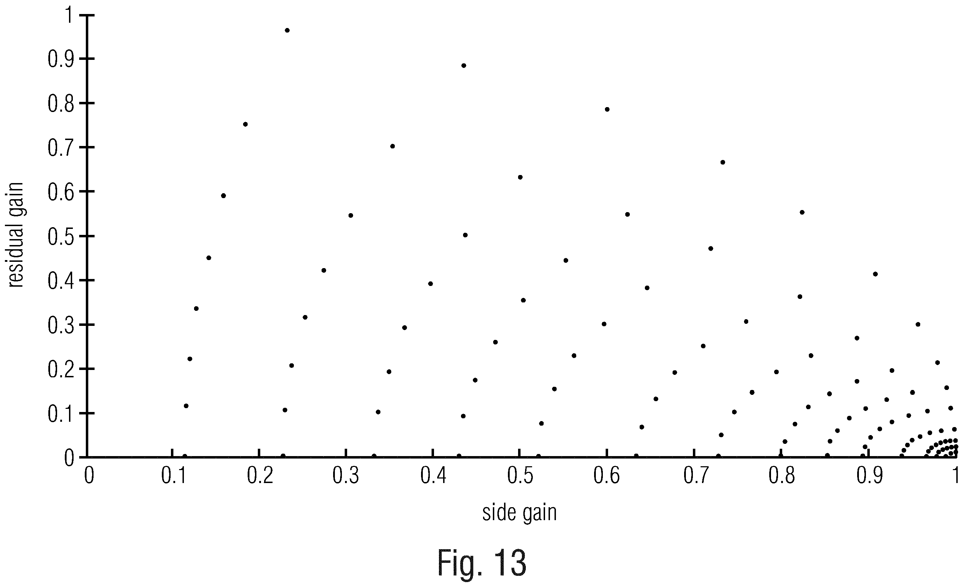

In particular, this is illustrated in Fig. 11 and analogously in Figs. 12 and 13 as well.

Fig. 1 shows the lines for the conditional quantization. In particular, it has been shown that the residual gain is always in a range determined by $(1-g^2)^{1/2}$. Thus, when g = 0, then r can be in a range between 0 and 1. However, when g is equal to 0.5, then r can be in the range of 0.866 and 0. Furthermore, when, for example, g = 0.75, then the range r is limited between 0 and 0.66. In an extreme embodiment where g = 0.9, then r can only range between 0 and 0.43. Furthermore, when g = 0.99, then r can only be in a range between 0 and 0.14, for example.

Thus, this dependency can be used by lowering the quantization step size for the quantization of the residual gain for higher side gains. Thus, when Fig. 11 is considered, the vertical lines that show the value range for r can always be divided by a certain integer number such as 8 so that each line has eight quantization steps. Thus, it is clear that for lines reflecting higher side gains, the quantization step is smaller than for lines that have lower side gains. Thus, higher side gains can be quantized more finely without any increase of bitrate.

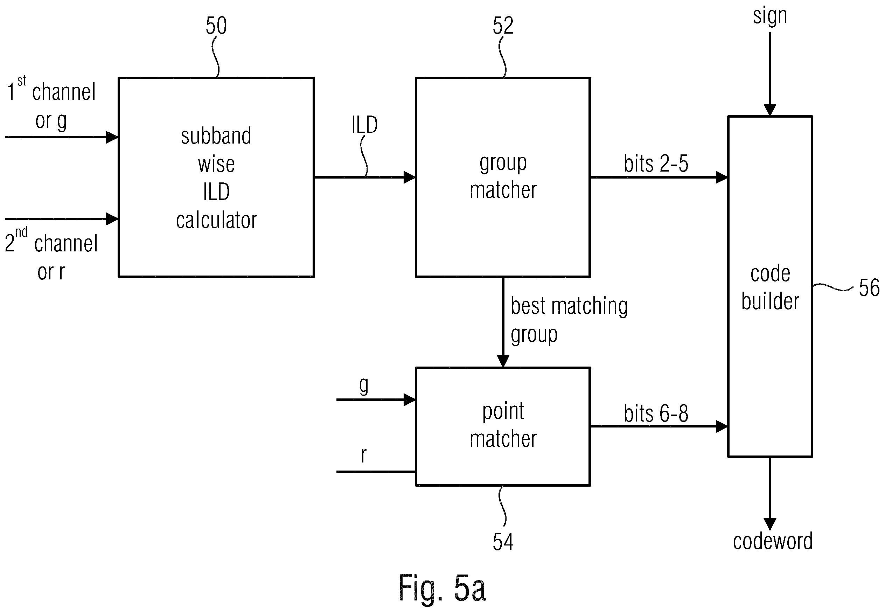

In a further embodiment, the quantizer is configured to perform a joint quantization using groups of quantization points, where each group of quantization points is defined by a fixed amplitude-related ratio between the first and the second channel. One example for an amplitude-related ratio is the energy between left and right, i.e., this means lines for the same ILD between the first and the second channel as illustrated in Fig. 12. In this embodiment, the output interface is configured as illustrated in Fig. 5a and comprises a subband-wise ILD calculator that receives, as an input, the first channel and the second channel or, alternatively, the side gain g and the residual gain r. The subband wise ILD calculator indicated by reference numeral 50 outputs a certain ILD for parameter values g, r to be quantized. The ILD or, generally, the amplitude-related ratio is forwarded to a group matcher 52. The group matcher 52 determines the best matching group and forwards this information to a point matcher 54. Both the group matcher 52 and the point matcher 54 feed a code builder 56 that finally outputs the code such as a codeword from a codebook.

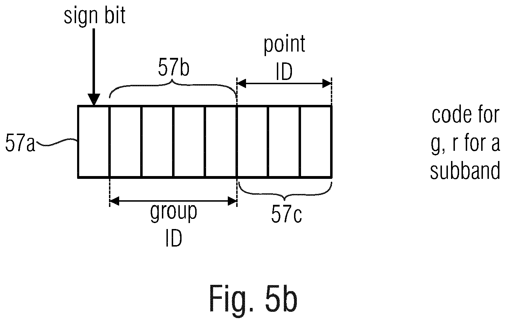

In particular, the code builder receives a sign of the side gain g and determines a sign bit 57a illustrated in Fig. 5b showing a code for g, r for a subband. Furthermore, the group matcher that has determined the certain group of quantization points matching with the determined ILD outputs bits 2 to 5 illustrated at 57b as the group ID. Finally, the point matcher outputs bits 6 to 8 in the embodiment of Fig. 5b illustrated at Fig. 57c, where these bits indicate the point ID, i.e., the ID of the quantization point within the group indicated by the bits 57b. Although Fig. 5b indicates an eight bit code having a single sign bit, four group bits and three point bits, other codes can be used having a sign bit and more or less group bits and more or less point bits. Due to the fact that the side gain has positive and negative values, the group bits and the point bits, i.e., the set of bits 57b and the set of bits 57c, only have either purely negative or, preferably, purely positive values and should the sign bit indicate an negative sign then the residual gain is decoded always as a positive value but the side gain is then decoded as a negative value which means that the energy of the left channel is lower than the energy of the right channel, when the rule as illustrated in equation 9 is applied for calculating the side gain.

Subsequently, further embodiments for the quantization are outlined

Quantization of side and residual gain

The inequalities in (11) reveal a strong dependence of the residual gain on the side gain, since the latter determines the range of the first. Quantizing the side gain $g$ and the residual gain $r$ independently by choosing quantization points in [-1,1] and [0,1] is therefore inefficient, since the number of possible quantization points for $r$ would decrease as g tends towards $\pm 1$.

Conditional Quantization

There are different ways to handle this problem. The easiest way is to quantize $g$ first and then to quantize $r$ conditional on the quantized value $\tilde{g}$ whence the quantization points will lie in the interval [0, $\sqrt{1 - \tilde{g}^2}$ ]. Quantization points can then e.g., be chosen uniformly on these quantization lines, some of which are depicted in Fig. 11.

Joint Quantization

A more sophisticated way to choose quantization points is to look at lines in the ($g$, $r$)-plane which correspond to a fixed energy ratio between $L$ and $R$. If $c^2 \ge 1$ denotes such an energy ratio, then the corresponding line is given by either (0, $s$) for $0 \le s \le 1$ if $c = 1$ or

$$(s, \sqrt{\frac{(1+s)^2 - c^2(1-s)^2}{c^2-1}}) \quad \text{for } \frac{c-1}{c+1} \le s \le \frac{c^2-1}{c^2+1} \tag{22}$$

This also covers the case $c^2 < 1$ since swapping $L_t$ and $R_t$ only changes the sign of $g_{t,b}$ and leaves $r_{t,b}$ unchanged.

This approach covers a larger region with the same number of quantization points as can be seen from Figure 12. Again, quantization points on the lines can e.g. be chosen uniformly according to the length of the individual lines. Other possibilities include choosing them in order to match pre-selected ICC- values or optimizing them in an acoustical way.

A quantization scheme that has been found to work well is based on energy lines corresponding to ILD values

$$\pm\{0,2,4,6,8,10,13,16,19,22,25,30,35,40,45,50\}, \tag{23}$$

on each of which 8 quantization points are selected. This gives rise to a code-book with 256 entries, which is organized as a 8 × 16 table of quantization points holding the values corresponding to non-negative values of g and a sign bit. This gives rise to a 8 bit integer representation of the quantization points ($g$, $r$) where e.g. the first bit specifies the sign of $g$, the next four bits hold the column index in the 8 × 16 table and the last three bits holding the row index.

Quantization of ($g_{t,b}$, $r_{t,b}$) could be done by an exhaustive code-book search, but it is more efficient to calculate the subband ILD first and restrict the search to the best-matching energy line. This way, only 8 points need to be considered.

Dequantization is done by a simple table lookup.

The 128 quantization points for this scheme covering the non-negative values of g are displayed in Figure 12.

Although a procedure has been disclosed for calculating the side gain and the residual gain without an actual calculation of the side signal, i.e., the difference signal between the left and the right signals as illustrated in equation (9) and equation (10), a further embodiment operates to calculate the side gain and the residual gain differently, i.e., with an actual calculation of the side signal. This procedure is illustrated in Fig. 3.

In this embodiment, the parameter calculator 140 illustrated in Fig. 1 comprises a side signal calculator 60 that receives, as an input, the first channel 101 and the second channel 102 and that outputs the actual side signal that can be in the time domain but that is preferably calculated in the frequency domain as, for example, illustrated by equation 3. However, although equation 3 indicates the situation of the calculation of the side signal with an absolute phase rotation parameter β and an IPD parameter per band and frame, the side signal can also be calculated without phase compensation. Equation 3 becomes an equation where only $L_{t,k}$ and $R_{t,k}$ occur. Thus, the side signal can also be calculated as a simple difference between left and right or first and second channels and the normalization with the square root of 2 can be used or not.

The side signal as calculated by the side signal calculator 60 is forwarded to a residual signal calculator 61. The residual signal calculator 62 performs the procedure illustrated in equation (5), for example. The residual signal calculator 61 is configured to use different test side gains, i.e., different values for the side gain $g_{d,b}$, i.e., different test side gains for one and the same band and frame and, consequently, different residual signals are obtained as illustrated by the multiple outputs of block 61.

The side gain selector 62 in Fig. 3 receives all the different residual signals and selects one of the different residual signals or, the test side gain associated with one of the different residual signals that fulfils a predefined condition. This predefined condition can, for example, be that the side gain is selected that has resulted in a residual signal having the smallest energy among all the different residual signals. However, other predetermined conditions can be used such as the smallest amplitude-related condition different from an energy such as a loudness. However, other procedures can also be applied such as that the residual signal is used that has not the smallest energy but the energy that is among the five smallest energies. Actually, a predefined condition can also be to select a residual signal that is showing a certain other audio characteristic such as certain features in certain frequency ranges.

The selected specific test side gain is determined by the side gain selector 62 as the side gain parameter for a certain frame or for a certain band and a certain frame. The selected residual signal is forwarded to the residual gain calculator 63 and the residual gain calculator can, in an embodiment, simply calculate the amplitude related characteristic of the selected residual signal or can, preferably, calculate the residual gain as a relation between the amplitude related characteristic of the residual signal with respect to the amplitude-related characteristic of the downmix signal or mid-signal. Even when a downmix is used that is different from a phase compensated downmix or is different from a downmix consisting of a sum of left and right, then the residual gain can, nevertheless, be related to a non-phase compensated addition of left and right, as the case may be.

Thus, Fig. 3 illustrates a way to calculate the side gain and the residual gain with an actual calculation of the side signal while, in the embodiment of Fig. 2 that roughly reflects equation 9 and equation 10, the side gain and the residual gain are calculated without explicit calculation of the side signal and without performing a residual signal calculation with different test side gains. Thus, it becomes clear that both embodiments result in a side gain and a residual gain parameterizing a residual signal from a prediction and other procedures for calculating the side gain and the residual gain apart from what is illustrated in Figs. 2 and 3 or by the corresponding equations 5 to 10 are also possible.

Furthermore, it is to be noted here that all the equations given are always the preferred embodiments for the values determined by the corresponding equations. However, it has been found that values that are different in a range of preferably +-20% from the values as determined by the corresponding equations are also useful and already provide advantages over the prior art, although the advantages become greater when the deviation from the values as determined by the equations becomes smaller. Thus, in other embodiments, it is preferred to use values that are only different from the values as determined by the corresponding equations by +-10% and, in a most preferred embodiment, the values determined by the equations are the values used for the calculation of the several data items.

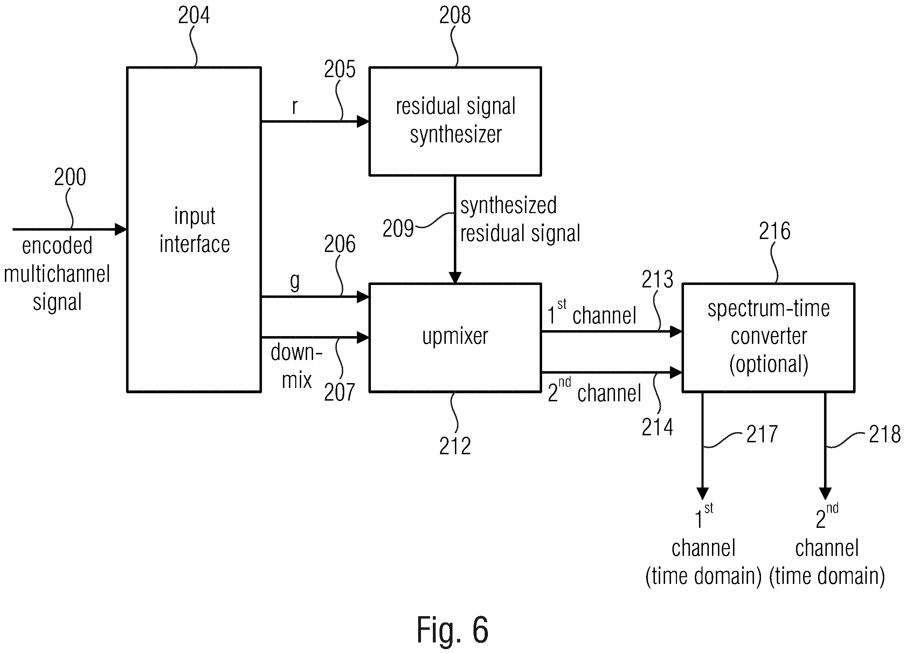

Fig. 6 illustrates an apparatus for decoding an encoded multichannel signal 200. The apparatus for decoding comprises an input interface 204, a residual signal synthesizer 208 connected to the input interface 204 and an upmixer 212 connected to the input interface 204 on the one hand and the residual synthesizer 208 on the other hand. In a preferred embodiment, the decoder additionally comprises a spectrum-time converter 260 in order to finally output time domain first and second channels as illustrated at 217 and 218.

In particular, the input interface 204 is configured for receiving the encoded multichannel signal 200 and for obtaining a downmix signal 207, a side gain g 206 and a residual gain r 205 from the encoded multichannel signal 200. The residual signal synthesizer 208 synthesizes a residual signal using the residual gain 205 and the upmixer 212 is configured for upmixing the downmix signal 207 using the side gain 206 and the residual signal 209 as determined by the residual signal synthesizer 208 to obtain a reconstructed first channel 213 and a reconstructed second channel 214. In the embodiment in which the residual signal synthesizer 208 and the upmixer 212 operate in the spectral domain or at least the upmixer 212 operates in the spectral domain, the reconstructed first and second channels 213, 214 are given in spectral domain representations and the spectral domain representation for each channel can be converted into the time domain by the spectrum-time converter 216 to finally output the time domain first and second reconstructed channels.

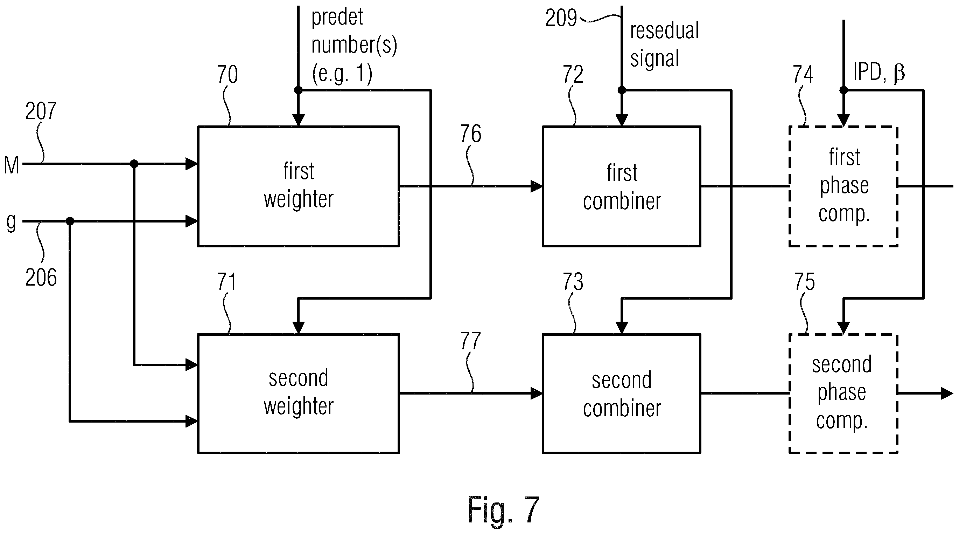

In particular, the upmixer 212 is configured to perform a first weighting operation using a first weighter 70 illustrated in Fig. 7 to obtain a first weighted downmix channel. Furthermore, the upmixer performs a second weighting operation using a second weighter again using the side gain 206 on the one hand and the downmix signal 207 on the other hand to obtain a second weighted downmix signal. Preferably, the first weighting operation performed by block 70 is different from the second weighting of operation performed by block 71 so that the first weighted downmix 76 is different from the second weighted downmix 77. Furthermore, the upmixer 212 is configured to calculate the reconstructed first channel using a combination performed by a first combiner 72 of the first weighted downmix signal 76 and the residual signal 209. Furthermore, the upmixer additionally comprises a second combiner 73 for performing a second combination of the second weighted downmix signal 77 and the residual signal 209.

Preferably, the combination rules performed by the first combiner 72 and the second combiner 73 are different from each other so that the output of block 72 on the one hand and block 73 on the other hand are substantially different to each other due to the different combining rules in block 72, 73 and due to the different weighting rules performed by block 70 and block 71.

Preferably, the first and the second combination rules are different from each other due to the fact that one combination rule is an adding operation and the other operation rule a subtracting operation. However, other pairs of first and second combination rules can be used as well.

Furthermore, the weighting rules used in block 70 and block 71 are different from each other, since one weighting rule uses a weighting with a weighting factor determined by a difference between a predetermined number and the side gain and the other weighting rule uses a weighting factor determined by a sum between a predetermined number and the side gain. The predetermined numbers can be equal to each other in both weighters or can be different from each other and the predetermined numbers are different from zero and can be integer or non-integer numbers and are preferably equal to 1.

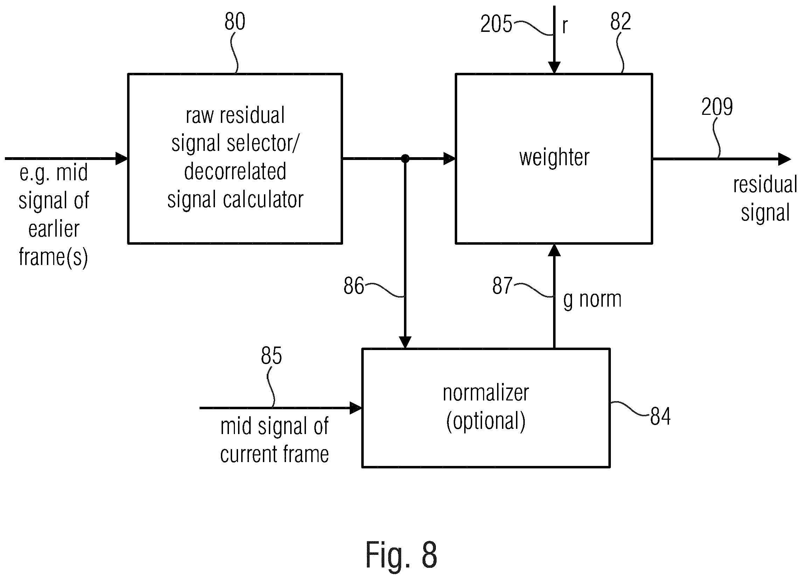

Fig. 8 illustrates a preferred implementation of the residual signal synthesizer 208. The residual signal synthesizer 208 comprises a kind of raw residual signal selector or, generally, a decorrelated signal calculator 80. Furthermore, the signal output by block 80 is input into a weighter 82 that receives, as an input, the residual gain output by the input inter face 204 of Fig. 6 indicated with the reference numeral 205. Furthermore, the residual signal synthesizer preferably comprises a normalizer 84 that receives, as an input, a mid signal of the current frame 85 and, as a further input, the signal output by block 80, i.e., the raw signal or decorrelated signal 86. Based on those two signals, the normalization factor $g_{norm}$ 87 is calculated, where the normalization factor 87 is preferably used by the weighter 82 together with the residual gain r to finally obtain the synthesized residual signal 209.

In a preferred embodiment, the raw residual signal selector 80 is configured for selecting a downmix signal of a preceding frame such as the immediately preceding frame or an even earlier frame. However, and depending on the implementation, the raw residual signal selector 80 is configured for selecting the left or right signal or first or second channel signal as calculated for a preceding frame or the raw residual signal selector 80 can also determine the residual signal based on, for example, a combination such as a sum, a difference or so of the left and right signal determined for either the immediately preceding frame or an even earlier preceding frame. In other embodiments, the decorrelated signal calculator 80 can also be configured to actually generate a decorrelated signal. However, it is preferred that the raw residual signal selector 80 operates without a specific decorrelator such as a decorrelation filter such as reverberation filter, but, for low complexity reasons, only selects an already existing signal from the past such as the mid signal, the reconstructed left signal, the reconstructed right signal or a signal derived from the earlier reconstructed left and right signal by simple operations such as a weighted combination, i.e., a (weighted) addition, a (weighted) subtraction or so that does not rely on a specific reverberation or a decorrelation filter.

Generally, the weighter 82 is configured to calculate the residual signal so that an energy of the residual signal is equal to a signal energy indicated by the residual gain r, where this energy can be indicated in absolute terms, but is preferably indicated in relative terms with respect to the mid signal 207 of the current frame.

In the preferred embodiments for the encoder side and the decoder side, values of the side gain and if appropriate from the residual gain are different from zero.

Subsequently, additional preferred embodiments for the decoder are given in equation form.

The upmix is again done in frequency domain. To this end, the time-frequency transform from the encoder is applied to the decoded downmix yielding time- frequency vectors $\tilde{M}_{t,b}$. Using the dequantized values $\widetilde{IPD}_{t,b}$, $\tilde{g}_{t,b}$, and $\tilde{r}_{t,b}$, left and right channel are calculated as

$$\tilde{L}_{t,k} = \frac{e^{i\tilde{\beta}}\left(\tilde{M}_{t,k}\left(1+\tilde{g}_{t,b}\right)+\tilde{r}_{t,b}g_{norm}\tilde{\rho}_{t,k}\right)}{\sqrt{2}}$$

(17)

and

$$\tilde{R}_{t,k} = \frac{e^{i\left(\tilde{\beta}-\widetilde{IPD}_b\right)}\left(\tilde{M}_{t,k}\left(1-\tilde{g}_{t,b}\right)-\tilde{r}_{t,b}g_{norm}\tilde{\rho}_{t,k}\right)}{\sqrt{2}}$$

(18)

for $k \in I_b$, where $\tilde{\rho}_{t,k}$ is a substitute for the missing residual $\rho_{t,k}$ from the encoder, and $g_{norm}$ is the energy adjusting factor

$$\sqrt{\frac{E_{\tilde{M},t,b}}{E_{\tilde{\rho},t,b}}}$$

$$(19)$$

that turns the relative gain coefficient $\tilde{r}_{t,b}$ into an absolute one. One may for instance take

$$\tilde{\rho}_{t,k} = \tilde{M}_{t-d_b,k},$$

$$(20)$$

where $d_b > 0$ denotes a band-wise frame-delay. The phase rotation factor $\tilde{\beta}$ is calculated again as

$$\tilde{\beta} = atan2(\sin(I\tilde{P}D_{t,b}), \cos(I\tilde{P}D_{t,b}) + 2\frac{1+\tilde{g}_{t,b}}{1-\tilde{g}_{t,b}})$$

$$(21)$$

The left channel and the right channel are then generated by applying the inverse DFT to $\tilde{L}_t$ and $\tilde{R}_t$ followed by a synthesis window and overlap add.

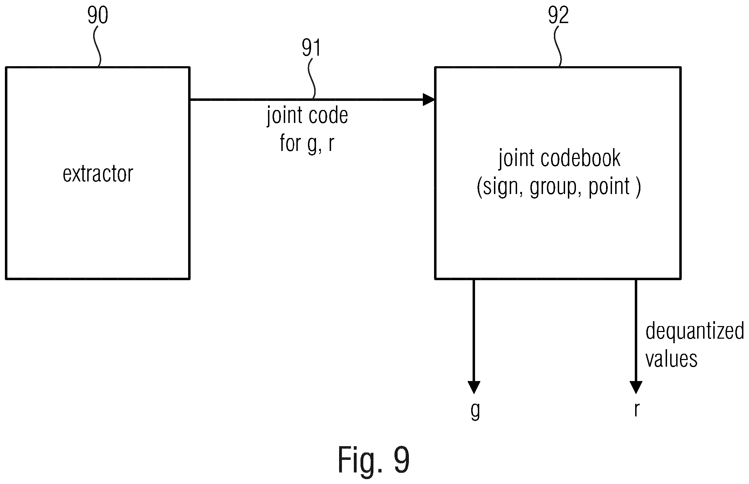

Fig. 9 illustrates a further embodiment of the input interface 204. This embodiment reflects the dequantization operation as discussed before for the encoder-side with respect to Figs. 5a and 5b. Particularly, the input interface 204 comprises an extractor 90 extracting a joint code from the encoded multichannel signal. This joint code 91 is forwarded to a joint codebook 92 that is configured to output, for each code, a sign information, a group information or a point information or to output, for each code, the final dequantized value g and the final dequantized value r, i.e., the dequantized side and residual gains.

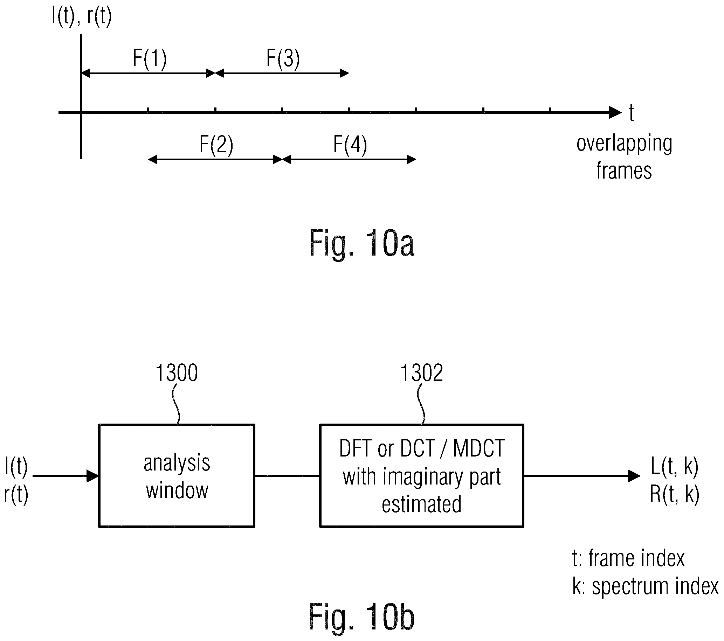

Fig. 10a illustrates a schematic representation of a time domain first and second channel or left and right channel $l(t)$ and $r(t)$.

In the embodiment, in which the side gain and the residual gain are calculated in the spectral domain, the left and right channels or first and second channels are separated into preferably overlapping frames F(1), F(2), F(3) and F(4) and so on. In the embodiment illustrated in Fig. 10a, the frames are overlapping by 50%, but other overlaps are useful as well. Furthermore, only a two-frame overlap is shown, i.e., that always only two subsequent frames overlap with each other. However, multi-overlap frames can be used as well, such as three, four or five overlapping frames. Then, the advance value, i.e., how much the following frame is different from the current frame is not 50% as in the embodiment illustrated in Fig. 10a, but is only smaller such as 10%, 20% or 30% or so.

Fig. 10b illustrates a preferred implementation of a time-spectral converter such as block 21 or block 22 illustrated in Fig. 2. Such a time-frequency converter receives, as an input, the sequence of frames $l(t)$ or $r(t)$. The analysis windower 1300 then outputs a sequence of windowed frames that all have been windowed with preferably the same analysis window. Analysis windows can be sine windows or any other windows and a separate sequence is calculated for the first channel and a further separate sequence is calculated for the second channel.

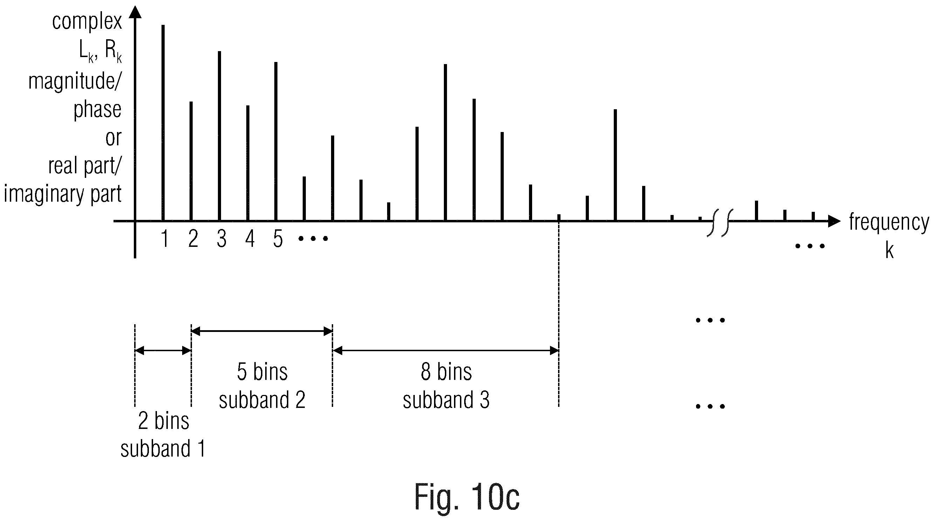

Then, the sequences of windowed frames are input into a transform block 1302. Preferably, the transform block 1302 performs a transform algorithm resulting in complex spectral values such as a DFT and, specifically, an FFT. In other embodiments, however, also a purely real transform algorithm such as a DCT or an MDCT (modified discrete cosine transform) can be used as well and, subsequently, the imaginary parts can be estimated from the purely real parts as is known in the art and as is, for example, implemented in the USAC (unified speech and audio coding) standard. Other transform algorithms can be sub-band filter banks such as QMF filter banks that result in complex-valued subband signals. Typically, subband signal filter bands have a lower frequency resolution than FFT algorithms and an FFT or DFT spectrum having a certain number of DFT bins can be transformed into a sub-band-wise representation by collecting certain bins. This is illustrated in Fig. 10c.

Particularly, Fig. 10c illustrates a complex spectrum of the frequency domain representation of the first or the second channel $L_k$, $R_k$ for a specific frame $t$. The spectral values are given in a magnitude/phase representation or in the real part/imaginary part representation. Typically, the DFT results in frequency bins having the same frequency resolution or bandwidth. Preferably, however, the side and residual gains are calculated subband-wise in order to reduce the number of bits for transmitting the residual and side gains. Preferably, the subband representation is generated using subbands that increase from lower to higher frequencies. Thus, in an example, subband 1 can have a first number of frequency bins such as two bins, and a second higher subband such as subband 2, subband 3, or any other subband can have a higher number of frequency bins such as, for example, eight frequency bins as illustrated by subband 3. Thus, the frequency bandwidth of the individual subbands can be preferably adjusted to the characteristics of the human ear as is known in the art with respect to the Bark scale.

Thus, Fig. 10c illustrates different frequency bins indicated by parameters $k$ in the equations disclosed before, and the individual subbands illustrated in Fig. 10c are indicated by subband index $b$.

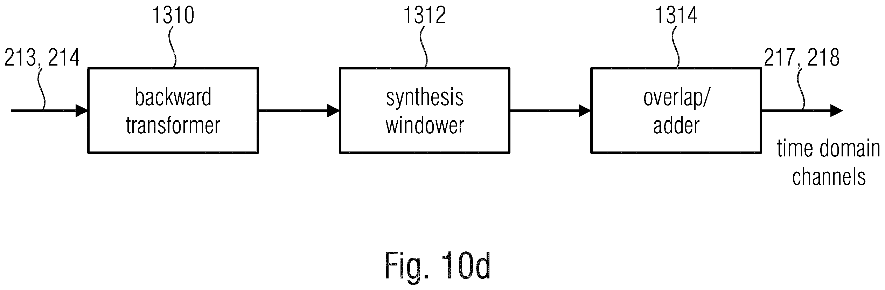

Fig. 10d illustrates an implementation of a spectrum-to-time converter as is, for example, implemented by block 216 in Fig. 6. The spectrum-time converter requires a backward transformer 1310, a subsequently connected synthesis windower 1312 and a subsequently connected overlap/adder 1314 to finally obtain the time domain channels. Thus, at the input into 1310 are the reconstructed spectral domain channels 213, 214 illustrated in Fig. 6, and at the output of the overlap/adder 1340, there exist the time domain reconstructed first and second channels 217, 218.

The backward transformer 1310 is configured to perform an algorithm resulting in a backward transform and, particularly, an algorithm that is preferably inverse to the algorithm applied in block 1302 of Fig. 10b on the encoder-side. Furthermore, the synthesis window 1312 is configured to apply a synthesis window that is matched with a corresponding analysis window and, preferably, the same analysis and synthesis windows are used, but this is not necessarily the case. The overlap adder 1314 is configured to perform an overlap as illustrated in Fig. 10a. Thus, the overlap/adder 1314, for example, takes the synthesis windowed frame corresponding to F(3) of Fig. 10a and additionally takes the synthesis windowed frame F(4) of Fig. 10a and then adds the corresponding samples of the second half of F(3) to the corresponding samples of the first half of F(4) in a sample-by-sample manner to finally obtain the samples of an actual time domain output channel.

Subsequently, different specific aspects of the present invention are given in short.

- Stereo M/S with IPD compensation and absolute phase compensation according to equation (4).
- Stereo M/S with IPD compensation and prediction of S by M according to (10)
- Stereo M/S with IPD compensation, prediction of S by M according to (9) and residual prediction according to gain factor (10)
- Efficient quantization of side and residual gain factors through joint quantization
- Joint quantization of side and residual gain factors on lines corresponding to a fixed energy ratio of $L_t$ and $R_t$ in the (g, r)-plane.

It is to be noted that, preferably, all of the above referenced five different aspects are implemented in one and the same encoder/decoder framework. However, it is additionally to be noted that the individual aspects given before can also be implemented separately from each other. Thus, the first aspect with the IPD compensation and absolute phase compensation can be performed in any downmixer irrespective of any side gain/residual gain calculation. Furthermore, for example, the aspect of the side gain calculation and the residual gain calculation can be performed with any downmix, i.e., also with a downmix that is not calculated by a certain phase compensation.

Furthermore, even the calculation of the side gain on the one hand and the residual gain on the other hand can be performed independent from each other, where the calculation of the side gain alone or together with any other parameter different from the residual gain is also advantageous over the art particularly, with respect to an ICC or ILD calculation and, even the calculation of the residual gain alone or together with any other parameter different from the side gain is also already useful.

Furthermore, the efficient joint or conditional quantization of the side and the residual gains or gain factors is useful with any particular downmix. Thus, the efficient quantization can also be used without any downmix at all. And, this efficient quantization can also be applied to any other parameters where the second parameter depends, with respect to its value range, from the first parameter so that a very efficient and low complex quantization can be performed for such dependent parameters that can, of course, be parameters different from the side gain and residual gain as well.

Thus, all of the above mentioned five aspects can be performed and implemented independent from each other or together in a certain encoder/decoder implementation, and, also, only a subgroup of the aspects can be implemented together, i.e., three aspects are implemented together without the other two aspects or only two out of the five aspects are implemented together without the other three aspects as the case may be.

Although some aspects have been described in the context of an apparatus, it is clear that these aspects also represent a description of the corresponding method, where a block or device corresponds to a method step or a feature of a method step. Analogously, aspects described in the context of a method step also represent a description of a corresponding block or item or feature of a corresponding apparatus.

Depending on certain implementation requirements, embodiments of the invention can be implemented in hardware or in software. The implementation can be performed using a digital storage medium, for example a floppy disk, a DVD, a CD, a ROM, a PROM, an EPROM, an EEPROM or a FLASH memory, having electronically readable control signals stored thereon, which cooperate (or are capable of cooperating) with a programmable computer system such that the respective method is performed.

Some embodiments according to the invention comprise a data carrier having electronically readable control signals, which are capable of cooperating with a programmable computer system, such that one of the methods described herein is performed.

Generally, embodiments of the present invention can be implemented as a computer program product with a program code, the program code being operative for performing one of the methods when the computer program product runs on a computer. The program code may for example be stored on a machine readable carrier.

Other embodiments comprise the computer program for performing one of the methods described herein, stored on a machine readable carrier or a non-transitory storage medium.

In other words, an embodiment of the inventive method is, therefore, a computer program having a program code for performing one of the methods described herein, when the computer program runs on a computer.

A further embodiment of the inventive methods is, therefore, a data carrier (or a digital storage medium, or a computer-readable medium) comprising, recorded thereon, the computer program for performing one of the methods described herein.

A further embodiment of the inventive method is, therefore, a data stream or a sequence of signals representing the computer program for performing one of the methods described herein. The data stream or the sequence of signals may for example be configured to be transferred via a data communication connection, for example via the Internet.

A further embodiment comprises a processing means, for example a computer, or a programmable logic device, configured to or adapted to perform one of the methods described herein.

A further embodiment comprises a computer having installed thereon the computer program for performing one of the methods described herein.

In some embodiments, a programmable logic device (for example a field programmable gate array) may be used to perform some or all of the functionalities of the methods described herein. In some embodiments, a field programmable gate array may cooperate with a microprocessor in order to perform one of the methods described herein. Generally, the methods are preferably performed by any hardware apparatus.

The above described embodiments are merely illustrative for the principles of the present invention. It is understood that modifications and variations of the arrangements and the details described herein will be apparent to others skilled in the art. It is the intent, therefore, to be limited only by the scope of the impending patent claims and not by the specific details presented by way of description and explanation of the embodiments herein.

References

MPEG-4 High Efficiency Advanced Audio Coding (HE-AAC) v2

FROM JOINT STEREO TO SPATIAL AUDIO CODING - RECENT PROGRESS AND STANDARDIZATION, Proc. of the 7th Int. Conference on digital Audio Effects (DAFX-04), Naples, Italy, October 5-8, 2004.

**Claims**

1. Apparatus for downmixing a multi-channel signal (100) comprising at least two channels (101, 102), comprising:

    a downmixer (120) for calculating (34) a downmix signal (122) from the multi-channel signal (100), wherein the downmixer is configured to calculate (34) the downmix using an absolute phase compensation, so that a channel having a lower energy among the at least two channels is only rotated or is rotated stronger than a channel having a greater energy in calculating the downmix signal (122); and
    an output interface (160) for generating an output signal, the output signal comprising information on the downmix signal (122).

2. Apparatus of claim 1,
    wherein the downmixer (120) is configured to calculate (30) an inter-channel phase difference using the at least two channels, and
    wherein the downmixer (120) is configured to calculate (32) an absolute phase rotation parameter, and

wherein the downmixer (120) is configured to weight (34), in calculating the downmix signal, the first channel and the second channel using the inter-channel phase difference and the absolute phase rotation parameter.

3. Apparatus of claim 2,
   wherein the apparatus further comprises a parameter calculator (140) for calculating a side gain (141) from a first channel (101) and a second channel (102) of the at least two channels, and
   wherein the downmixer (120) is configured to calculate (32) the absolute phase rotation parameter based on the side gain (141) determined by the parameter calculator (140).

4. Apparatus of one of claims 2 or 3,
   wherein the downmixer (120) is configured to calculate (30) the inter-channel phase difference for each sub-band of a frame, and wherein the downmixer (120) is configured to calculate (32) the absolute phase rotation parameter for each sub-band of the frame.

5. Apparatus of one claims 1 to 4,
   wherein the downmixer (120) is configured to calculate the absolute phase rotation parameter so that the absolute phase rotation parameter is within ± 20% of values determined by the following equation:

$$ ß = \mathrm{atan}(\sin(IPD_{t,b}), \cos(IPD_{t,b}) + A\frac{1+g_{t,b}}{1-g_{t,b}}) \qquad , $$

wherein atan is an arctangent function, wherein $\beta$ is the absolute phase rotation parameter, wherein IPD is the inter-channel phase difference, wherein t is a frame index, b is a sub-band index, and $g_{t,b}$ is the side gain for the frame t and the sub-band b, and wherein A is a value between 0.1 and 100 or between -0.1 and -100.

6. Apparatus of claim 5, wherein the atan function comprises an atan2 function, the atan2(y,x) function being the two argument arctangent function whose value is the angle between the point *(x,y)* and the positive *x-axis.*

7. Apparatus of one of claims 1 to 6,
   wherein the downmixer (120) is configured to calculate (34) the downmix signal (122) so that the downmix signal (122) has values within ± 20% of values determined by the following equation:

$$ M_{t,k} = \frac{e^{-iß}L_{t,k} + e^{i(IPD_{t,b}-ß)}R_{t,k}}{\sqrt{2}} \qquad , $$

wherein $M_{t,k}$ is a downmix signal for the frame t and the frequency bin k, wherein $L_{t,k}$ is the first channel for the frame t and the frequency bin k, wherein $R_{t,k}$ is the second channel for the frame t and the frequency bin k, wherein $IPD_{t,b}$ is an inter-channel phase difference for the frame t and the sub-band b comprising the frequency bin k, and wherein $\beta$ is the phase rotation parameter.

8. Apparatus of one of claims 1 to 7, further comprising:

   a parameter calculator (140) for calculating a side gain (141) from a first channel (101) of the at least two channels and a second channel (102) of the at least two channels or for calculating a residual gain (142) from the first channel (101) and the second channel (102); and
   an output interface (160) for generating an output signal, the output signal comprising information on the downmix signal (122), and on the side gain (141) and the residual gain (142).

9. Apparatus of one of claims 3, 5, 8, wherein the parameter calculator (140) is configured:

   to generate (21) a sub-bandwise representation of the first channel and the second channel,
   to calculate (21, 22, 23, 24) a first amplitude-related characteristic of the first channel in a sub-band and to calculate a second amplitude-related characteristic of the second channel in the sub-band,
   to calculate (25) an inner product of the first channel and the second channel in the sub-band;
   to calculate (26) the side gain in the sub-band using a first relation involving the first amplitude-related characteristic, the second amplitude-related characteristic, and the inner product; or

to calculate (27) the residual gain in the sub-band using a second relation involving the first amplitude-related characteristic, the second amplitude-related characteristic, and the inner product, the second relation being different from the first relation,
wherein the amplitude-related characteristic is determined from amplitudes, from powers, from energies or from any powers of amplitudes with an exponent greater than 1.

10. Apparatus of claim 3, 5, 8 or 9,
wherein the parameter calculator (140) is configured to calculate, for each sub-band of a plurality of sub-bands of the first channel and the second channel, the side gain (141) or the residual gain (142), or
wherein the parameter calculator is configured to calculate the side gain as a side prediction gain that is applicable to a mid signal of the first and the second channels to predict a side signal of the first and the second channels, or
wherein the parameter calculator (140) is configured to calculate the residual gain as a residual prediction gain indicating an amplitude-related characteristic of a residual signal of a prediction of the side signal by the mid signal using the side gain.

11. Apparatus of one of the one of claims 3, 5, 8 to 10,
wherein the parameter calculator (140) is configured to calculate (26) the side gain using a fraction having a nominator and a denominator, the nominator involving an amplitude-related characteristic of the first channel and an amplitude-related characteristic of the second channel, and the denominator involving the amplitude-related characteristic of the first channel and the amplitude-related characteristic of the second channel and a value derived from the inner product, or
wherein the parameter calculator (140) is configured to calculate (27) the residual gain using a fraction having a nominator and a denominator, the nominator involving a value derived from the inner product, and the denominator involving the inner product.

12. Apparatus of claim 11,
wherein the parameter calculator (140) is configured to calculate (26) the side gain, wherein the nominator comprises a difference of the first amplitude-related characteristic of the first channel and a second amplitude-related characteristic of the second channel, and where the denominator comprises a sum of the first amplitude-related characteristic of the first channel and the second amplitude-related characteristic of the second channel and a value derived from the inner product, or
wherein the parameter calculator (140) is configured to calculate (27) the residual gain using the fraction having the nominator and the denominator, wherein the nominator comprises a difference between a weighted sum of the first amplitude-related characteristic of the first channel and the second amplitude-related characteristic of the second channel and a value derived from the inner product, and wherein the denominator comprises the sum of the amplitude-related characteristic of the first channel, the amplitude-related characteristic of the second channel and a value derived from the inner product.

13. Apparatus of one of the claims 3, 5, 8 to 12,
wherein the parameter calculator (140) is configured to calculate the side gain for a sub-band and to calculate the residual gain for the sub-band using (28) the side gain for the sub-band.

14. Apparatus of one of the claims 3, 5, 8 to 12,
wherein the parameter calculator (140) is configured to calculate the side gain so that values for the side gain are in a range of $\pm$ 20% of values determined based on the following equation:

$$g_{t,b} = \frac{E_{L,t,b} - E_{R,t,b}}{E_{L,t,b} + E_{R,t,b} + 2X_{L/R,t,b}} \,,$$

or
wherein the parameter calculator (140) is configured to calculate the residual gain so that values for the residual gain are in a range of $\pm$ 20% of values determined based on the following equation:

$$r_{t,b} = \left( \frac{(1-g_{t,b})E_{L,t,b} + (1+g_{t,b})E_{R,t,b} - 2X_{L/R,t,b}}{E_{L,t,b} + E_{R,t,b} + 2X_{L/R,t,b}} \right)^{1/2} \,,$$

wherein t is a frame index, wherein b is a sub-band index, wherein $E_l$ is an energy of the left channel in the frame and the sub-band, wherein $E_R$ is an energy of the second channel in the frame t and the sub-band b, and wherein X is the inner product between the first channel and the second channel in the frame t and the sub-band b.

15. Apparatus of one of the claims 3, 5, 8 to 14,
wherein the parameter calculator (140) is configured to calculate a sub-band-wise representation of the first channel and the second channel as a sequence of complex valued spectra, wherein each spectrum is related to a time frame of the first or the second channel, wherein the time frames of the sequence being adjacent in the sequence of spectra and overlap with each other, or
wherein the parameter calculator (140) is configured to calculate the first amplitude-related measure and the second amplitude-related measure by squaring magnitudes of complex spectral values in a sub-band and by summing squared magnitudes in the sub-band, or
wherein the parameter calculator (140) is configured to calculate an inner product by summing, in the sub-band, products, wherein each product involves a spectral value in a frequency bin of the first channel and a conjugate complex spectral value of the second channel for the frequency bin, and by forming a magnitude of a result of the summing.

16. Apparatus of one of the preceding claims,
wherein the output interface (160) comprises a waveform encoder configured to waveform encode the downmix signal (122) to obtain the information on the downmix signal (122), or
wherein the downmixer is configured to rotate the channel having the lower energy more than the channel having the higher energy only when the energy difference between the channels is greater than a predefined threshold.

17. Apparatus for upmixing an encoded multi-channel signal (200), comprising:

an input interface (204) for receiving the encoded multi-channel signal (200) and for obtaining a downmix signal (207) from the encoded multi-channel signal (200);
an upmixer (212) for upmixing the downmix signal (207), wherein the upmixer is configured to calculate a reconstructed first channel (213) and a reconstructed second channel (214) using an absolute phase compensation, so that the downmix signal is, in reconstructing a channel having a lower energy among the reconstructed first channel (213) and a reconstructed second channel (214), only rotated or is rotated stronger than a channel having a greater energy among the reconstructed first channel (213) and a reconstructed second channel (214).

18. The apparatus of one claim 17,
wherein the input interface (204) is configured to obtain, from the encoded multichannel signal (200), inter-channel phase difference values, and
wherein the upmixer (212) is configured to apply the inter-channel phase difference values when calculating the reconstructed first and second channels.

19. Apparatus of claim 18, wherein the upmixer (212) is configured
to calculate a phase rotation parameter from an inter-channel phase difference value and
to apply the phase rotation parameter when calculating the reconstructed first channel in a first manner and to apply the inter-channel phase difference value and/or the phase rotation parameter when calculating the reconstructed second channel in a second manner, wherein the first manner is different from the second manner.

20. Apparatus of claim 19,
wherein the input interface (204) is configured for receiving the encoded multi-channel signal (200) and for obtaining a side gain (206) from the encoded multi-channel signal (200);
wherein the upmixer (212) is configured to calculate the phase rotation parameter so that the absolute phase rotation parameter is within $\pm$ 20% of values determined by the following equation:

$$ ß = \mathrm{atan}\left(\sin\left(IPD_{t,b}\right), \cos\left(IPD_{t,b}\right) + A\frac{1+g_{t,b}}{1-g_{t,b}}\right) $$

wherein atan is an arctangent function, wherein β is the absolute phase rotation parameter, wherein IPD is the inter-channel phase difference, wherein t is a frame index, b is a sub-band index, and $g_{t,b}$ is the side gain for the frame t and the sub-band b, and wherein A is a value between 0.1 and 100 or between -0.1 and -100.

**21.** Apparatus of claim 20, wherein the atan function comprises an atan2 function, the atan2(y,x) function being the two argument arctangent function whose value is the angle between the point *(x,y)* and the positive *x-axis.*

**22.** Apparatus of claim 20 or 21,
wherein the upmixer (212) is configured to calculate the reconstructed first channel and the reconstructed second channel so that the reconstructed first channel and the reconstructed second channel have values that are in the range of $\pm$ 20 % with respect to values as determined by the following equations:

$$\widetilde{L}_{t,k} = \frac{e^{i\widetilde{\beta}}\widetilde{M}_{t,k}}{\sqrt{2}}$$

and

$$\widetilde{R}_{t,k} = \frac{e^{i(\beta - \overline{IPD}_b)}\widetilde{M}_{t,k}}{\sqrt{2}}$$

wherein $\tilde{M}_{t,k}$ is the downmix signal for the frame t and the frequency bin k.

**23.** Apparatus of claim 19 or 20 or 21,
wherein the upmixer (212) is configured to calculate the reconstructed first channel and the reconstructed second channel so that the reconstructed first channel and the reconstructed second channel have values that are in the range of $\pm$ 20 % with respect to values as determined by the following equations:

$$\widetilde{L}_{t,k} = \frac{e^{i\widetilde{\beta}}\left(\widetilde{M}_{t,k}\left(1+\widetilde{g}_{t,b}\right)+\tilde{r}_{t,b}g_{norm}\widetilde{\rho}_{t,k}\right)}{\sqrt{2}}$$

and

$$\widetilde{R}_{t,k} = \frac{e^{i(\beta - \overline{IPD}_b)}\left(\widetilde{M}_{t,k}\left(1-\widetilde{g}_{t,b}\right)-\tilde{r}_{t,b}g_{norm}\widetilde{\rho}_{t,k}\right)}{\sqrt{2}}$$

wherein $\tilde{M}_{t,k}$ is the downmix signal for the frame t and the frequency bin k, wherein $\tilde{g}_{t,b}$ is the side gain for the frame t and the subband b, wherein $\tilde{r}_{t,b}$ is a residual gain for the frame t and the suband b, wherein $g_{norm}$ is an energy adjusting factor that can be there or not, and wherein $\tilde{\rho}_{t,k}$ is a raw residual signal for the frame t and the frequency bin k.

**24.** Apparatus of any one of the claims 17 to 23,
wherein the input interface (204) is configured for receiving the encoded multi-channel signal (200) and for obtaining a side gain (206) and a residual gain (205) from the encoded multi-channel signal (200);
wherein the apparatus further comprises a residual signal synthesizer (208) for synthesizing a residual signal (209) using the residual gain (205);
wherein the upmixer (212) is configured to perform a first weighting operation (70) of the downmix signal (207) using the side gain (206) to obtain a first weighted downmix signal (76),
wherein the upmixer (212) is configured to perform a second weighting operation (71) using the side gain (206) and the downmix signal (207) to obtain a second weighted downmix signal (77),
wherein the first weighting operation (70) is different from the second weighting operation (71), so that the first weighted downmix signal (76) is different from the second weighted downmix signal (77), and
wherein the upmixer (212) is configured to calculate the reconstructed first channel using a combination (72) of the first weighted downmix signal (76) and the residual signal (209) and using a second combination (73) of the second weighted downmix signal (77) and the residual signal (209).

**25.** Apparatus of claim 24,
wherein the upmixer (212) is configured to combine (72) the weighted downmix signal (76) and the residual signal (209) in calculating the reconstructed first channel, and
wherein the upmixer (212) is configured to combine (73) the second weighted downmix signal (77) and the residual signal (209) using a second combination rule (73) in calculating the reconstructed second channel, wherein the first combination rule (72) and the second combination rule (73) are different from each other, or

wherein one of the first and the second combination rules (72, 73) is an adding operation and the other of the first and the second combination rules is a subtracting operation.

26. Apparatus of one of claims 23 to 25,
wherein the upmixer (212) is configured to perform the first weighting operation (70) comprising a weighting factor derived from a sum of the side gain and the first predetermined number, and
wherein the upmixer (212) is configured to perform the second weighting operation (71) comprising a weighting factor derived from a difference between a second predetermined number and the side gain, wherein the first and second predetermined numbers are equal to each other or are different from each other.

27. Apparatus of one of claims 23 to 26,
wherein the residual signal synthesizer (208) is configured to weight a downmix signal (207) of a preceding frame using the residual gain (209) for a current frame to obtain the residual signal (209) for the current frame, or
to weight (88) a decorrelated signal derived (80) from the current frame or from one or more preceding frames using the residual gain (205) for the current frame to obtain the residual signal (209) for the current frame.

28. Apparatus of one of claims 23 to 27,
wherein the residual signal calculator (208) is configured to calculate the residual signal (209) so that an energy of the residual signal (209) is equal to a signal energy indicated by the residual gain (205).

29. Apparatus of one of claims 23 to 28,
wherein the residual signal calculator (208) is configured to calculate the residual signal so that values of the residual signal are in a range of $\pm$ 20% of values determined based on the following equation:

$$\tilde{R}_{t,k} = \frac{\tilde{r}_{t,b} g_{norm} \tilde{\rho}_{t,k}}{\sqrt{2}} ,$$

wherein $R_{t,k}$ is the residual signal for frame t and frequency bin k, wherein $\tilde{r}_{t,b}$ is the residual gain for the frame t and the sub-band b comprising the frequency bin k, and wherein $\tilde{\rho}_{t,k}$ is a residual signal, and wherein $g_{norm}$ is an energy-adjusting factor that can be present or not.

30. Apparatus of one of claims 23 to 29,
wherein $g_{norm}$ is an energy normalization factor having values in the range of $\pm$ 20% of values determined by the following equation:

$$\sqrt{\frac{E_{\tilde{M},t,b}}{E_{\tilde{\rho},t,b}}} ,$$

wherein $E_{\tilde{M},t,b}$ is the energy of the downmix signal for the frame t and the sub-band b, and wherein $E_{\tilde{\rho},t,b}$ is the energy of the residual signal for the sub-band b and the frame t, or
wherein a raw signal for the residual signal is determined based on the following equation:

$$\tilde{\rho}_{t,k} = \tilde{M}_{t-d_b,k} ,$$

wherein $\tilde{\rho}_{t,k}$ is the raw signal for the residual signal,
wherein $\tilde{M}_{t-d_b,k}$ is the downmix signal for the frame $t-t_b$ and the frequency bin k, wherein $d_b$ is a frame delay greater than 0, or

wherein the upmixer (212) is configured to calculate the reconstructed first channel and the reconstructed second channel so that the reconstructed first channel and the reconstructed second channel have values that are in the range of $\pm$ 20 % with respect to values as determined by the following equations:

$$\widetilde{L}_{t,k} = \frac{e^{i\beta}\left(\widetilde{M}_{t,k}\left(1+\widetilde{g}_{t,b}\right)+\widetilde{r}_{t,b}g_{norm}\widetilde{\rho}_{t,k}\right)}{\sqrt{2}}$$

and

$$\widetilde{R}_{t,k} = \frac{e^{i(\beta-\overline{IPD}_b)}\left(\widetilde{M}_{t,k}\left(1-\widetilde{g}_{t,b}\right)-\widetilde{r}_{t,b}g_{norm}\widetilde{\rho}_{t,k}\right)}{\sqrt{2}}$$

wherein $\widetilde{M}_{t,k}$ is the downmix signal for the frame t and the frequency bin k, wherein $\widetilde{g}_{t,b}$ is the side gain for the frame t and the subband b, wherein $\widetilde{r}_{t,b}$ is the residual gain for the frame t and the suband b, wherein $g_{norm}$ is an energy adjusting factor that can be there or not, and wherein $\widetilde{\rho}_{t,k}$ is a raw residual signal for the frame t and the frequency bin k.

31. Apparatus of one of claims 17 to 30,
   wherein the upmixer (212) is configured to calculate the reconstructed first channel (213) and the reconstructed second channel (214) in a spectral domain,
   wherein the apparatus further comprises a spectrum-time converter (216) for converting the reconstructed first channel and the reconstructed second channel into a time domain,
   wherein the upmixer is configured to rotate the channel having the lower energy more than the channel having the higher energy only when the energy difference between the channels is greater than a predefined threshold.

32. Apparatus of claim 31,
   wherein the spectrum-time converter (216) is configured to (301) convert, for each one of the first and the second reconstructed channels, subsequent frames into a time sequence of frames
   to weight (1312) each time frame using a synthesis window; and
   to overlap and add (1314) subsequent windowed time frames to obtain a time block of the first reconstructed channel (217) and the time block of the second reconstructed channel 218.

33. Method of downmixing a multi-channel signal (100) comprising at least two channels (101, 102), comprising:

   calculating (34) a downmix signal (122) from the multi-channel signal (100), wherein the calculating comprises calculating the downmix using an absolute phase compensation, so that a channel having a lower energy among the at least two channels is only rotated or is rotated stronger than a channel having a greater energy in calculating the downmix signal (122); and
   generating (160) an output signal, the output signal comprising information on the downmix signal (122).

34. Method of upmixing an encoded multi-channel signal (200), comprising:

   receiving (204) the encoded multi-channel signal (200) and obtaining a downmix signal (207) from the encoded multi-channel signal (200);
   upmixing (212) the downmix signal (207), the upmixing comprising calculating a reconstructed first channel (213) and a reconstructed second channel (214) using an absolute phase compensation, so that the downmix signal is, in reconstructing a channel having a lower energy among the reconstructed first channel (213) and a reconstructed second channel (214), only rotated or is rotated stronger than a channel having a greater energy among the reconstructed first channel (213) and a reconstructed second channel (214).

35. Computer program for performing, when running on the computer or a processor, the method of claim 33 or the method of claim 34.

## Patentansprüche

1. Vorrichtung zum Abwärtsmischen eines Mehrkanalsignals (100), das zumindest zwei Kanäle (101, 102) aufweist, wobei die Vorrichtung folgende Merkmale aufweist:

   einen Abwärtsmischer (120) zum Berechnen (34) eines Abwärtsmischsignals (122) aus dem Mehrkanalsignal (100), wobei der Abwärtsmischer dazu ausgebildet ist, die Abwärtsmischung unter Verwendung einer Absolutphasenkompensation zu berechnen (34), so dass bei dem Berechnen des Abwärtsmischsignals (122) nur ein Kanal mit einer niedrigeren Energie unter den zumindest zwei Kanälen gedreht wird oder stärker gedreht wird als ein Kanal mit einer größeren Energie; und

eine Ausgangsschnittstelle (160) zum Erzeugen eines Ausgangssignals, wobei das Ausgangssignal Informationen über das Abwärtsmischsignal (122) aufweist.

2. Vorrichtung gemäß Anspruch 1,
wobei der Abwärtsmischer (120) dazu ausgebildet ist, eine Zwischenkanalphasendifferenz unter Verwendung der zumindest zwei Kanäle zu berechnen (30), und
wobei der Abwärtsmischer (120) dazu ausgebildet ist, einen Absolutphasendrehungsparameter zu berechnen (32), und
wobei der Abwärtsmischer (120) dazu ausgebildet ist, bei dem Berechnen des Abwärtsmischsignals den ersten Kanal und den zweiten Kanal unter Verwendung der Zwischenkanalphasendifferenz und des Absolutphasendrehungsparameters zu gewichten (34).

3. Vorrichtung gemäß Anspruch 2,
wobei die Vorrichtung ferner eine Parameterberechnungseinrichtung (140) zum Berechnen eines Seitengewinns bzw. eines Side Gains (141) aus einem ersten Kanal (101) und einem zweiten Kanal (102) der zumindest zwei Kanäle aufweist, und
wobei der Abwärtsmischer (120) dazu ausgebildet ist, den Absolutphasendrehungsparameter auf der Basis des Seitengewinns (141) zu berechnen (32), der durch die Parameterberechnungseinrichtung (140) bestimmt wird.

4. Vorrichtung gemäß einem der Ansprüche 2 oder 3,
wobei der Abwärtsmischer (120) dazu ausgebildet ist, die Zwischenkanalphasendifferenz für jedes Teilband eines Rahmens zu berechnen (30), und wobei der Abwärtsmischer (120) dazu ausgebildet ist, den Absolutphasendrehungsparameter für jedes Teilband des Rahmens zu berechnen (32).

5. Vorrichtung gemäß einem der Ansprüche 1 bis 4,
wobei der Abwärtsmischer (120) dazu ausgebildet ist, den Absolutphasendrehungsparameter zu berechnen, so dass der Absolutphasendrehungsparameter innerhalb von $\pm$ 20 % von Werten liegt, die durch die folgende Gleichung bestimmt werden:

$$\text{ß} = \text{atan}\left(\sin\left(IPD_{t,b}\right), \cos\left(IPD_{t,b}\right) + A\,\frac{1+g_{t,b}}{1-g_{t,b}}\right)$$

wobei atan eine Arkustangensfunktion ist, wobei $\beta$ der Absolutphasendrehungsparameter ist, wobei IPD die Zwischenkanalphasendifferenz ist, wobei t ein Rahmenindex ist, b ein Teilbandindex ist und $g_{t,b}$ der Seitengewinn für den Rahmen t und das Teilband b ist, und wobei A ein Wert zwischen 0,1 und 100 oder zwischen -0,1 und -100 ist.

6. Vorrichtung gemäß Anspruch 5, wobei die atan-Funktion eine atan2-Funktion aufweist, wobei die atan2(y,x)-Funktion die Zwei-Argumente-Arkustangensfunktion ist, deren Wert der Winkel zwischen dem Punkt (x,y) und der positiven x-Achse ist.

7. Vorrichtung gemäß einem der Ansprüche 1 bis 6,
wobei der Abwärtsmischer (120) dazu ausgebildet ist, das Abwärtsmischsignal (122) zu berechnen (34), so dass das Abwärtsmischsignal (122) Werte innerhalb von $\pm$ 20 % von Werten aufweist, die durch die folgende Gleichung bestimmt werden:

$$M_{t,k} = \frac{e^{-i\text{ß}}L_{t,k} + e^{i(IPD_{t,b}-\text{ß})}R_{t,k}}{\sqrt{2}}$$

wobei $M_{t,k}$ ein Abwärtsmischsignal für den Rahmen t und den Frequenzintervallbereich k ist, wobei $L_{t,k}$ der erste Kanal für den Rahmen t und den Frequenzintervallbereich k ist, wobei $R_{t,k}$ der zweite Kanal für den Rahmen t und den Frequenzintervallbereich k ist, wobei $IPD_{t,b}$ eine Zwischenkanalphasendifferenz für den Rahmen t und das Teilband b ist, das den Frequenzintervallbereich k aufweist, und wobei $\beta$ der Phasendrehungsparameter ist.

8. Vorrichtung gemäß einem der Ansprüche 1 bis 7, die ferner folgende Merkmale aufweist:

eine Parameterberechnungseinrichtung (140) zum Berechnen eines Seitengewinns (141) aus einem ersten Kanal (101) der zumindest zwei Kanäle und einem zweiten Kanal (102) der zumindest zwei Kanäle oder zum Berechnen eines Restgewinns (142) aus dem ersten Kanal (101) und dem zweiten Kanal (102); und
eine Ausgangsschnittstelle (160) zum Erzeugen eines Ausgangssignals, wobei das Ausgangssignal Informationen über das Abwärtsmischsignal (122) und über den Seitengewinn (141) und den Restgewinn (142) aufweist.

9. Vorrichtung gemäß einem der Ansprüche 3, 5, 8, wobei die Parameterberechnungseinrichtung (140) dazu ausgebildet ist,
eine teilbandweise Darstellung des ersten Kanals und des zweiten Kanals zu erzeugen (21),
eine erste amplitudenbezogene Charakteristik des ersten Kanals in einem Teilband zu berechnen (21, 22, 23, 24) und eine zweite amplitudenbezogene Charakteristik des zweiten Kanals in dem Teilband zu berechnen,
ein inneres Produkt des ersten Kanals und des zweiten Kanals in dem Teilband zu berechnen (25);
den Seitengewinn in dem Teilband unter Verwendung einer ersten Beziehung zu berechnen (26), die die erste amplitudenbezogene Charakteristik, die zweite amplitudenbezogene Charakteristik und das innere Produkt beinhaltet; oder
den Restgewinn in dem Teilband unter Verwendung einer zweiten Beziehung zu berechnen (27), die die erste amplitudenbezogene Charakteristik, die zweite amplitudenbezogene Charakteristik und das innere Produkt beinhaltet, wobei sich die zweite Beziehung von der ersten Beziehung unterscheidet,
wobei die amplitudenbezogene Charakteristik aus Amplituden, aus Potenzen, aus Energien oder aus beliebigen Potenzen von Amplituden mit einem Exponenten bestimmt werden, der größer ist als 1.

10. Vorrichtung gemäß Anspruch 3, 5, 8 oder 9,
wobei die Parameterberechnungseinrichtung (140) dazu ausgebildet ist, für jedes Teilband einer Mehrzahl von Teilbändern des ersten Kanals und des zweiten Kanals den Seitengewinn (141) oder den Restgewinn (142) zu berechnen, oder
wobei die Parameterberechnungseinrichtung dazu ausgebildet ist, den Seitengewinn als einen Seitenvorhersagegewinn zu berechnen, der auf ein Mittensignal des ersten und des zweiten Kanals anwendbar ist, um ein Seitensignal des ersten und des zweiten Kanals vorherzusagen, oder
wobei die Parameterberechnungseinrichtung (140) dazu ausgebildet ist, den Restgewinn als einen Restvorhersagegewinn zu berechnen, der eine amplitudenbezogene Charakteristik eines Restsignals einer Vorhersage des Seitensignals durch das Mittensignal unter Verwendung des Seitengewinns anzeigt.

11. Vorrichtung gemäß einem der Ansprüche 3, 5, 8 bis 10,
wobei die Parameterberechnungseinrichtung (140) dazu ausgebildet ist, den Seitengewinn unter Verwendung eines Bruchs mit einem Zähler und einem Nenner zu berechnen (26), wobei der Zähler eine amplitudenbezogene Charakteristik des ersten Kanals und eine amplitudenbezogene Charakteristik des zweiten Kanals beinhaltet, und wobei der Nenner die amplitudenbezogene Charakteristik des ersten Kanals und die amplitudenbezogene Charakteristik des zweiten Kanals und einen von dem inneren Produkt abgeleiteten Wert beinhaltet, oder
wobei die Parameterberechnungseinrichtung (140) dazu ausgebildet ist, den Restgewinn unter Verwendung eines Bruchs mit einem Zähler und einem Nenner zu berechnen (27), wobei der Zähler einen von dem inneren Produkt abgeleiteten Wert beinhaltet und der Nenner das innere Produkt beinhaltet.

12. Vorrichtung gemäß Anspruch 11,
wobei die Parameterberechnungseinrichtung (140) dazu ausgebildet ist, den Seitengewinn zu berechnen (26), wobei der Zähler eine Differenz aus der ersten amplitudenbezogenen Charakteristik des ersten Kanals und einer zweiten amplitudenbezogenen Charakteristik des zweiten Kanals aufweist, und wobei der Nenner eine Summe aus der ersten amplitudenbezogenen Charakteristik des ersten Kanals und der zweiten amplitudenbezogenen Charakteristik des zweiten Kanals und einen von dem inneren Produkt abgeleiteten Wert aufweist, oder
wobei die Parameterberechnungseinrichtung (140) dazu ausgebildet ist, den Restgewinn unter Verwendung des Bruchs mit dem Zähler und dem Nenner zu berechnen (27), wobei der Zähler eine Differenz zwischen einer gewichteten Summe aus der ersten amplitudenbezogenen Charakteristik des ersten Kanals und der zweiten amplitudenbezogenen Charakteristik des zweiten Kanals und einem von dem inneren Produkt abgeleiteten Wert aufweist, und wobei der Nenner die Summe aus der amplitudenbezogenen Charakteristik des ersten Kanals, der amplitudenbezogenen Charakteristik des zweiten Kanals und einen von dem inneren Produkt abgeleiteten Wert aufweist.

13. Vorrichtung gemäß einem der Ansprüche 3, 5, 8 bis 12,

wobei die Parameterberechnungseinrichtung (140) dazu ausgebildet ist, den Seitengewinn für ein Teilband zu berechnen und den Restgewinn für das Teilband unter Verwendung (28) des Seitengewinns für das Teilband zu berechnen.

14. Vorrichtung gemäß einem der Ansprüche 3, 5, 8 bis 12,
    wobei die Parameterberechnungseinrichtung (140) dazu ausgebildet ist, den Seitengewinn zu berechnen, so dass Werte für den Seitengewinn in einem Bereich von $\pm$ 20 % von Werten liegen, die auf der Basis der folgenden Gleichung bestimmt werden:

$$g_{t,b} = \frac{E_{L,t,b} - E_{R,t,b}}{E_{L,t,b} + E_{R,t,b} + 2X_{L/R,t,b}} ,$$

oder
wobei die Parameterberechnungseinrichtung (140) dazu ausgebildet ist, den Restgewinn zu berechnen, so dass Werte für den Restgewinn in einem Bereich von $\pm$ 20 % von Werten liegen, die auf der Basis der folgenden Gleichung bestimmt werden:

$$r_{t,b} = \left( \frac{(1-g_{t,b})E_{L,t,b} + (1+g_{t,b})E_{R,t,b} - 2X_{L/R,t,b}}{E_{L,t,b} + E_{R,t,b} + 2X_{L/R,t,b}} \right)^{1/2} ,$$

wobei t ein Rahmenindex ist, wobei b ein Teilbandindex ist, wobei $E_l$ eine Energie des linken Kanals in dem Rahmen und dem Teilband ist, wobei $E_R$ eine Energie des zweiten Kanals in dem Rahmen t und dem Teilband b ist, und wobei X das innere Produkt zwischen dem ersten Kanal und dem zweiten Kanal in dem Rahmen t und dem Teilband b ist.

15. Vorrichtung gemäß einem der Ansprüche 3, 5, 8 bis 14,
    wobei die Parameterberechnungseinrichtung (140) dazu ausgebildet ist, eine teilbandweise Darstellung des ersten Kanals und des zweiten Kanals als eine Sequenz komplexwertiger Spektren zu berechnen, wobei jedes Spektrum auf einen Zeitrahmen des ersten oder des zweiten Kanals bezogen ist, wobei die Zeitrahmen der Sequenz in der Sequenz von Spektren benachbart sind und einander überlappen, oder
    wobei die Parameterberechnungseinrichtung (140) dazu ausgebildet ist, das erste amplitudenbezogene Maß und das zweite amplitudenbezogene Maß durch Quadrieren von Größen komplexer Spektralwerte in einem Teilband und durch Summieren quadrierter Größen in dem Teilband zu berechnen, oder
    wobei die Parameterberechnungseinrichtung (140) dazu ausgebildet ist, ein inneres Produkt zu berechnen, indem Produkte in dem Teilband summiert werden, wobei jedes Produkt einen Spektralwert in einem Frequenzintervallbereich des ersten Kanals und einen konjugiert-komplexen Spektralwert des zweiten Kanals für den Frequenzintervallbereich beinhaltet, und indem eine Größe eines Ergebnisses des Summierens gebildet wird.

16. Vorrichtung gemäß einem der vorhergehenden Ansprüche,
    wobei die Ausgangsschnittstelle (160) einen Signalverlaufcodierer aufweist, der dazu ausgebildet ist, das Abwärtsmischsignal (122) einer Signalverlaufcodierung zu unterziehen, um die Informationen über das Abwärtsmischsignal (122) zu erhalten, oder
    wobei der Abwärtsmischer dazu ausgebildet ist, den Kanal mit der niedrigeren Energie nur dann mehr zu drehen als den Kanal mit der höheren Energie, wenn die Energiedifferenz zwischen den Kanälen größer ist als eine vordefinierte Schwelle.

17. Vorrichtung zum Aufwärtsmischen eines codierten Mehrkanalsignals (200), die folgende Merkmale aufweist:

    eine Eingangsschnittstelle (204) zum Empfangen des codierten Mehrkanalsignals (200) und zum Erhalten eines Abwärtsmischsignals (207) aus dem codierten Mehrkanalsignal (200);
    einen Aufwärtsmischer (212) zum Aufwärtsmischen des Abwärtsmischsignals (207), wobei der Aufwärtsmischer dazu ausgebildet ist, einen rekonstruierten ersten Kanal (213) und einen rekonstruierten zweiten Kanal (214) unter Verwendung einer Absolutphasenkompensation zu berechnen, so dass das Abwärtsmischsignal bei einem Rekonstruieren eines Kanals mit einer niedrigeren Energie unter dem rekonstruierten ersten Kanal (213) und einem rekonstruierten zweiten Kanal (214) nur gedreht wird oder stärker gedreht wird als ein Kanal mit einer größeren Energie unter dem rekonstruierten ersten Kanal (213) und einem rekonstruierten zweiten Kanal (214).

**18.** Vorrichtung gemäß Anspruch 17,
wobei die Eingangsschnittstelle (204) dazu ausgebildet ist, aus dem codierten Mehrkanalsignal (200) Zwischenkanalphasendifferenzwerte zu erhalten, und
wobei der Aufwärtsmischer (212) dazu ausgebildet ist, die Zwischenkanalphasendifferenzwerte bei einem Berechnen des rekonstruierten ersten und des rekonstruierten zweiten Kanals anzuwenden.

**19.** Vorrichtung gemäß Anspruch 18, wobei der Aufwärtsmischer (212) dazu ausgebildet ist,
einen Phasendrehungsparameter aus einem Zwischenkanalphasendifferenzwert zu berechnen und
den Phasendrehungsparameter bei dem Berechnen des rekonstruierten ersten Kanals auf eine erste Weise anzuwenden und den Zwischenkanalphasendifferenzwert und/oder den Phasendrehungsparameter bei dem Berechnen des rekonstruierten zweiten Kanals auf eine zweite Weise anzuwenden, wobei sich die erste Weise von der zweiten Weise unterscheidet.

**20.** Vorrichtung gemäß Anspruch 19,
wobei die Eingangsschnittstelle (204) dazu ausgebildet ist, das codierte Mehrkanalsignal (200) zu empfangen und einen Seitengewinn (206) aus dem codierten Mehrkanalsignal (200) zu erhalten;
wobei der Aufwärtsmischer (212) dazu ausgebildet ist, den Phasendrehungsparameter zu berechnen, so dass der Absolutphasendrehungsparameter innerhalb von $\pm$ 20 % von Werten liegt, die durch die folgende Gleichung bestimmt werden:

$$ß = \operatorname{atan}(\sin(IPD_{t,b}), \cos(IPD_{t,b}) + A\,\frac{1+g_{t,b}}{1-g_{t,b}})$$ ,

wobei atan eine Arkustangensfunktion ist, wobei $\beta$ der Absolutphasendrehungsparameter ist, wobei IPD die Zwischenkanalphasendifferenz ist, wobei t ein Rahmenindex ist, b ein Teilbandindex ist und $g_{t,b}$ der Seitengewinn für den Rahmen t und das Teilband b ist, und wobei A ein Wert zwischen 0,1 und 100 oder zwischen -0,1 und -100 ist.

**21.** Vorrichtung gemäß Anspruch 20, wobei die atan-Funktion eine atan2-Funktion aufweist, wobei die atan2(y,x)-Funktion die Zwei-Argumente-Arkustangensfunktion ist, deren Wert der Winkel zwischen dem Punkt (x,y) und der positiven x-Achse ist.

**22.** Vorrichtung gemäß Anspruch 20 oder 21,
wobei der Aufwärtsmischer (212) dazu ausgebildet ist, den rekonstruierten ersten Kanal und den rekonstruierten zweiten Kanal zu berechnen, so dass der rekonstruierte erste Kanal und der rekonstruierte zweite Kanal Werte aufweisen, die in dem Bereich von $\pm$ 20 % in Bezug auf Werte liegen, wie sie durch die folgenden Gleichungen bestimmt werden:

$$\widetilde{L}_{t,k} = \frac{e^{i\beta}\widetilde{M}_{t,k}}{\sqrt{2}}$$

und

$$\widetilde{R}_{t,k} = \frac{e^{i(\beta-\widetilde{IPD}_b)}\widetilde{M}_{t,k}}{\sqrt{2}}$$

wobei $\widetilde{M}_{t,k}$ das Abwärtsmischsignal für den Rahmen t und den Frequenzintervallbereich k ist.

**23.** Vorrichtung gemäß Anspruch 19 oder 20 oder 21,
wobei der Aufwärtsmischer (212) dazu ausgebildet ist, den rekonstruierten ersten Kanal und den rekonstruierten zweiten Kanal zu berechnen, so dass der rekonstruierte erste Kanal und der rekonstruierte zweite Kanal Werte aufweisen, die in dem Bereich von $\pm$ 20 % in Bezug auf Werte liegen, wie sie durch die folgenden Gleichungen bestimmt werden:

$$\widetilde{L}_{t,k} = \frac{e^{i\widetilde{\beta}}\left(\widetilde{M}_{t,k}\left(1+\widetilde{g}_{t,b}\right)+\widetilde{r}_{t,b}g_{norm}\widetilde{\rho}_{t,k}\right)}{\sqrt{2}}$$

und

$$\widetilde{R}_{t,k} = \frac{e^{i\left(\beta-\overline{IPD}_b\right)}\left(\widetilde{M}_{t,k}\left(1-\widetilde{g}_{t,b}\right)-\widetilde{r}_{t,b}g_{norm}\widetilde{\rho}_{t,k}\right)}{\sqrt{2}}$$

wobei $\widetilde{M}_{t,k}$ das Abwärtsmischsignal für den Rahmen t und den Frequenzintervallbereich k ist, wobei $\widetilde{g}_{t,b}$ der Seitengewinn für den Rahmen t und das Teilband b ist, wobei $\widetilde{r}_{t,b}$ ein Restgewinn für den Rahmen t und das Teilband b ist, wobei $g_{norm}$ ein energieanpassender Faktor ist, der vorhanden sein kann oder nicht, und wobei $\widetilde{\rho}_{t,k}$ ein rohes Restsignal für den Rahmen t und den Frequenzintervallbereich k ist.

24. Vorrichtung gemäß einem der Ansprüche 17 bis 23,
wobei die Eingangsschnittstelle (204) dazu ausgebildet ist, das codierte Mehrkanalsignal (200) zu empfangen und einen Seitengewinn (206) und einen Restgewinn (205) aus dem codierten Mehrkanalsignal (200) zu erhalten;
wobei die Vorrichtung ferner einen Restsignalsynthetisierer (208) zum Synthetisieren eines Restsignals (209) unter Verwendung des Restgewinns (205) aufweist;
wobei der Aufwärtsmischer (212) dazu ausgebildet ist, einen ersten Gewichtungsvorgang (70) des Abwärtsmischsignals (207) unter Verwendung des Seitengewinns (206) durchzuführen, um ein erstes gewichtetes Abwärtsmischsignal (76) zu erhalten,
wobei der Aufwärtsmischer (212) dazu ausgebildet ist, einen zweiten Gewichtungsvorgang (71) unter Verwendung des Seitengewinns (206) und des Abwärtsmischsignals (207) durchzuführen, um ein zweites gewichtetes Abwärtsmischsignal (77) zu erhalten,
wobei sich der erste Gewichtungsvorgang (70) von dem zweiten Gewichtungsvorgang (71) unterscheidet, so dass sich das erste gewichtete Abwärtsmischsignal (76) von dem zweiten gewichteten Abwärtsmischsignal (77) unterscheidet, und
wobei der Aufwärtsmischer (212) dazu ausgebildet ist, den rekonstruierten ersten Kanal unter Verwendung einer Kombination (72) aus dem ersten gewichteten Abwärtsmischsignal (76) und dem Restsignal (209) und unter Verwendung einer zweiten Kombination (73) aus dem zweiten gewichteten Abwärtsmischsignal (77) und dem Restsignal (209) zu berechnen.

25. Vorrichtung gemäß Anspruch 24,
wobei der Aufwärtsmischer (212) dazu ausgebildet ist, das gewichtete Abwärtsmischsignal (76) und das Restsignal (209) bei dem Berechnen des rekonstruierten ersten Kanals zu kombinieren (72), und
wobei der Aufwärtsmischer (212) dazu ausgebildet ist, das zweite gewichtete Abwärtsmischsignal (77) und das Restsignal (209) unter Verwendung einer zweiten Kombinationsregel (73) bei dem Berechnen des rekonstruierten zweiten Kanals zu kombinieren (73), wobei sich die erste Kombinationsregel (72) und die zweite Kombinationsregel (73) voneinander unterscheiden, oder
wobei eine der ersten und der zweiten Kombinationsregel (72, 73) eine Additionsoperation und die andere der ersten und der zweiten Kombinationsregel eine Subtraktionsoperation ist.

26. Vorrichtung gemäß einem der Ansprüche 23 bis 25,
wobei der Aufwärtsmischer (212) dazu ausgebildet ist, den ersten Gewichtungsvorgang (70) durchzuführen, der einen Gewichtungsfaktor aufweist, der von einer Summe aus dem Seitengewinn und der ersten vorbestimmten Zahl abgeleitet ist, und
wobei der Aufwärtsmischer (212) dazu ausgebildet ist, den zweiten Gewichtungsvorgang (71) durchzuführen, der einen Gewichtungsfaktor aufweist, der von einer Differenz zwischen einer zweiten vorbestimmten Zahl und dem Seitengewinn abgeleitet ist, wobei die erste und die zweite vorbestimmte Zahl gleich oder voneinander verschieden sind.

27. Vorrichtung gemäß einem der Ansprüche 23 bis 26,
wobei der Restsignalsynthetisator (208) dazu ausgebildet ist, ein Abwärtsmischsignal (207) eines vorhergehenden Rahmens unter Verwendung des Restgewinns (209) für einen aktuellen Rahmen zu gewichten, um das Restsignal (209) für den aktuellen Rahmen zu erhalten, oder
ein dekorreliertes Signal, das von dem aktuellen Rahmen oder von einem oder mehreren vorhergehenden Rahmen abgeleitet (80) ist, unter Verwendung des Restsignals (205) für den aktuellen Rahmen zu gewichten (88), um das Restsignal (209) für den aktuellen Rahmen zu erhalten.

**28.** Vorrichtung gemäß einem der Ansprüche 23 bis 27,
wobei die Restsignalberechnungseinrichtung (208) dazu ausgebildet ist, das Restsignal (209) zu berechnen, so dass eine Energie des Restsignals (209) gleich einer Signalenergie ist, die durch den Restgewinn (205) angezeigt ist.

**29.** Vorrichtung gemäß einem der Ansprüche 23 bis 28,
wobei die Restsignalberechnungseinrichtung (208) dazu ausgebildet ist, das Restsignal zu berechnen, so dass Werte des Restsignals in einem Bereich von $\pm$ 20 % von Werten liegen, die auf der Basis der folgenden Gleichung bestimmt werden:

$$\tilde{R}_{t,k} = \frac{\tilde{r}_{t,b} g_{norm} \tilde{\rho}_{t,k}}{\sqrt{2}} \, ,$$

wobei $\tilde{R}_{t,k}$ das Restsignal für den Rahmen t und den Frequenzintervallbereich k ist, wobei $\tilde{r}_{t,b}$ der Restgewinn für den Rahmen t und das Teilband b ist, das den Frequenzintervallbereich k aufweist, und wobei $\tilde{\rho}_{t,k}$ ein Restsignal ist, und wobei $g_{norm}$ ein energieanpassender Faktor ist, der vorhanden sein kann oder nicht.

**30.** Vorrichtung gemäß einem der Ansprüche 23 bis 29,
wobei $g_{norm}$ ein Energienormierungsfaktor mit Werten in dem Bereich von $\pm$ 20 % von Werten ist, die durch die folgende Gleichung bestimmt werden:

$$\sqrt{\frac{E_{\tilde{M},t,b}}{E_{\tilde{\rho},t,b}}} \, ,$$

wobei $E_{\tilde{M},t,b}$ die Energie des Abwärtsmischsignals für den Rahmen t und das Teilband b ist, und wobei $E_{\tilde{\rho},t,b}$ die Energie des Restsignals für das Teilband b und den Rahmen t ist, oder
wobei ein Rohsignal für das Restsignal auf der Basis der folgenden Gleichung bestimmt wird:

$$\tilde{\rho}_{t,k} = \tilde{M}_{t-d_b,k} \, ,$$

wobei $\tilde{\rho}_{t,k}$ das Rohsignal für das Restsignal ist,
wobei $\tilde{M}_{t-d_b,k}$ das Abwärtsmischsignal für den Rahmen t-$t_b$ und den Frequenzintervallbereich k ist, wobei $d_b$ eine Rahmenverzögerung ist, die größer ist als 0, oder

wobei der Aufwärtsmischer (212) dazu ausgebildet ist, den rekonstruierten ersten Kanal und den rekonstruierten zweiten Kanal zu berechnen, so dass der rekonstruierte erste Kanal und der rekonstruierte zweite Kanal Werte aufweisen, die in dem Bereich von $\pm$ 20 % in Bezug auf Werte liegen, wie sie durch die folgenden Gleichungen bestimmt werden:

$$\tilde{L}_{t,k} = \frac{e^{i\beta}\left(\tilde{M}_{t,k}\left(1+\tilde{g}_{t,b}\right)+\tilde{r}_{t,b} g_{norm} \tilde{\rho}_{t,k}\right)}{\sqrt{2}}$$

und

$$\tilde{R}_{t,k} = \frac{e^{i(\beta-\overline{IPD}_b)}\left(\tilde{M}_{t,k}\left(1-\tilde{g}_{t,b}\right)-\tilde{r}_{t,b} g_{norm} \tilde{\rho}_{t,k}\right)}{\sqrt{2}}$$

wobei $\tilde{M}_{t,k}$ das Abwärtsmischsignal für den Rahmen t und den Frequenzintervallbereich k ist, wobei $\tilde{g}_{t,b}$ der Seitengewinn für den Rahmen t und das Teilband b ist, wobei $\tilde{r}_{t,b}$ der Restgewinn für den Rahmen t und das Teilband b ist, wobei $g_{norm}$ ein energieanpassender Faktor ist, der vorhanden sein kann oder nicht, und wobei $\tilde{\rho}_{t,k}$ ein rohes Restsignal für den Rahmen t und den Frequenzintervallbereich k ist.

**31.** Vorrichtung gemäß einem der Ansprüche 17 bis 30,
wobei der Aufwärtsmischer (212) dazu ausgebildet ist, den rekonstruierten ersten Kanal (213) und den rekonstruierten zweiten Kanal (214) in einem Spektralbereich zu berechnen,
wobei die Vorrichtung ferner einen Spektrum-Zeit-Wandler (216) zum Umwandeln des rekonstruierten ersten Kanals und des rekonstruierten zweiten Kanals in einen Zeitbereich aufweist,
wobei der Aufwärtsmischer dazu ausgebildet ist, den Kanal mit der niedrigeren Energie nur dann mehr zu drehen als den Kanal mit der höheren Energie, wenn die Energiedifferenz zwischen den Kanälen größer ist als eine vordefinierte Schwelle.

**32.** Vorrichtung gemäß Anspruch 31,
wobei der Spektrum-Zeit-Wandler (216) dazu ausgebildet ist, für sowohl den ersten als auch den zweiten rekonstruierten Kanal nachfolgende Rahmen in eine Zeitsequenz von Rahmen umzuwandeln (301),
um jeden Zeitrahmen unter Verwendung eines Synthesefensters zu gewichten (1312); und
aufeinanderfolgende gefensterte Zeitrahmen zu überlappen und zu addieren (1314), um einen Zeitblock des ersten rekonstruierten Kanals (217) und den Zeitblock des zweiten rekonstruierten Kanals (218) zu erhalten.

**33.** Verfahren zum Abwärtsmischen eines Mehrkanalsignals (100), das zumindest zwei Kanäle (101, 102) aufweist, wobei das Verfahren folgende Schritte aufweist:

Berechnen (34) eines Abwärtsmischsignals (122) aus dem Mehrkanalsignal (100), wobei das Berechnen ein Berechnen der Abwärtsmischung unter Verwendung einer Absolutphasenkompensation aufweist, so dass bei dem Berechnen des Abwärtsmischsignals (122) nur ein Kanal mit einer niedrigeren Energie unter den zumindest zwei Kanälen gedreht wird oder stärker gedreht wird als ein Kanal mit einer größeren Energie; und
Erzeugen (160) eines Ausgangssignals, wobei das Ausgangssignal Informationen über das Abwärtsmischsignal (122) aufweist.

**34.** Verfahren zum Aufwärtsmischen eines codierten Mehrkanalsignals (200), das folgende Schritte aufweist:

Empfangen (204) des codierten Mehrkanalsignals (200) und zum Erhalten eines Abwärtsmischsignals (207) aus dem codierten Mehrkanalsignal (200);
Aufwärtsmischen (212) des Abwärtsmischsignals (207), wobei das Aufwärtsmischen ein Berechnen eines rekonstruierten ersten Kanals (213) und eines rekonstruierten zweiten Kanals (214) unter Verwendung einer Absolutphasenkompensation aufweist, so dass das Abwärtsmischsignal bei einem Rekonstruieren eines Kanals mit einer niedrigeren Energie unter dem rekonstruierten ersten Kanal (213) und einem rekonstruierten zweiten Kanal (214) nur gedreht wird oder stärker gedreht wird als ein Kanal mit einer größeren Energie unter dem rekonstruierten ersten Kanal (213) und einem rekonstruierten zweiten Kanal (214).

**35.** Computerprogramm zum Durchführen, wenn dasselbe auf dem Computer oder einem Prozessor läuft, des Verfahrens gemäß Anspruch 33 oder des Verfahrens gemäß Anspruch 34.

## Revendications

**1.** Appareil de mélange vers le bas d'un signal multicanal (100) comprenant au moins deux canaux (101, 102), comprenant:

un mélangeur vers le bas (120) destiné à calculer (34) un signal de mélange vers le bas (122) à partir du signal multicanal (100), où le mélangeur vers le bas est configuré pour calculer (34) le mélange vers le bas à l'aide d'une compensation de phase absolue, de sorte qu'un canal présentant une énergie inférieure parmi les au moins deux canaux soit uniquement tourné ou soit tourné plus fortement qu'un canal présentant une plus grande énergie lors du calcul du signal de mélange vers le bas (122); et
une interface de sortie (160) destinée à générer un signal de sortie, le signal de sortie comprenant des informations sur le signal de mélange vers le bas (122).

**2.** Appareil selon la revendication 1,
dans lequel le mélangeur vers le bas (120) est configuré pour calculer (30) une différence de phase entre canaux à l'aide des au moins deux canaux, et
dans lequel le mélangeur vers le bas (120) est configuré pour calculer (32) un paramètre de rotation de phase

EP 3 539 126 B1

absolue, et

dans lequel le mélangeur vers le bas (120) est configuré pour pondérer (34), lors du calcul du signal de mélange vers le bas, le premier canal et le deuxième canal à l'aide de la différence de phase entre canaux et du paramètre de rotation de phase absolue.

3.  Appareil selon la revendication 2,
    dans lequel l'appareil comprend par ailleurs un calculateur de paramètres (140) destiné à calculer un gain latéral (141), ou un Side Gain, à partir d'un premier canal (101) et d'un deuxième canal (102) des au moins deux canaux, et dans lequel le mélangeur vers le bas (120) est configuré pour calculer (32) le paramètre de rotation de phase absolue sur base du gain latéral (141) déterminé par le calculateur de paramètres (140).

4.  Appareil selon l'une des revendications 2 ou 3,
    dans lequel le mélangeur vers le bas (120) est configuré pour calculer (30) la différence de phase entre canaux pour chaque sous-bande d'une trame, et dans lequel le mélangeur vers le bas (120) est configuré pour calculer (32) le paramètre de rotation de phase absolue pour chaque sous-bande de la trame.

5.  Appareil selon l'une des revendications 1 à 4,
    dans lequel le mélangeur vers le bas (120) est configuré pour calculer le paramètre de rotation de phase absolue de sorte que le paramètre de rotation de phase absolue se situe dans une plage de $\pm$ 20% des valeurs déterminées par l'équation suivante:

$$ß = \mathrm{atan}(sin(IPD_{t,b}), cos(IPD_{t,b}) + A\frac{1 + g_{t,b}}{1 - g_{t,b}}),$$

où atan est une fonction arc-tangente, où $\beta$ est le paramètre de rotation de phase absolue, où IPD est la différence de phase entre canaux, où t est un indice de trame, b est un indice de sous-bande, et $g_{t,b}$ est le gain latéral pour la trame t et la sous-bande b, et où A est une valeur comprise entre 0,1 et 100 ou entre -0,1 et -100.

6.  Appareil selon la revendication 5, dans lequel la fonction atan comprend une fonction atan2, la fonction atan2 (y, x) étant la fonction arc-tangente à deux arguments dont la valeur est l'angle entre le point (x, y) et l'axe x positif.

7.  Appareil selon l'une des revendications 1 à 6,
    dans lequel le mélangeur vers le bas (120) est configuré pour calculer (34) le signal de mélange vers le bas (122) de sorte que le signal de mélange vers le bas (122) présente des valeurs comprises dans une plage de $\pm$ 20% des valeurs déterminées par l'équation suivante:

$$M_{t,k} = \frac{e^{-iß}L_{t,k} + e^{i(IPD_{t,b}-ß)}R_{t,k}}{\sqrt{2}},$$

où $M_{t,k}$ est un signal de mélange vers le bas pour la trame t et le bin de fréquences k, où $L_{t,k}$ est le premier canal pour la trame t et le bin de fréquences k, où $R_{t,k}$ est le deuxième canal pour la trame t et le bin de fréquences k, où $IPD_{t,k}$ est une différence de phase entre canaux pour la trame t et la sous-bande b comprenant le bin de fréquences k, et où $\beta$ est le paramètre de rotation de phase.

8.  Appareil selon l'une des revendications 1 à 7, comprenant par ailleurs:

    un calculateur de paramètres (140) destiné à calculer un gain latéral (141) à partir d'un premier canal (101) des au moins deux canaux et un deuxième canal (102) des au moins deux canaux ou pour calculer un gain résiduel (142) à partir du premier canal (101) et du deuxième canal (102); et
    une interface de sortie (160) destinée à générer un signal de sortie, le signal de sortie comprenant les informations sur le signal de mélange vers le bas (122), et sur le gain latéral (141) et le gain résiduel (142).

9.  Appareil selon l'une des revendications 3, 5, 8, dans lequel le calculateur de paramètres (140) est configuré:

    pour générer (21) une représentation par sous-bande du premier canal et du deuxième canal,

pour calculer (21, 22, 23, 24) une première caractéristique relative à l'amplitude du premier canal dans une sous-bande et pour calculer une deuxième caractéristique relative à l'amplitude du deuxième canal dans la sous-bande,

pour calculer (25) un produit interne du premier canal et du deuxième canal dans la sous-bande;

pour calculer (26) le gain latéral dans la sous-bande à l'aide d'un premier rapport impliquant la première caractéristique relative à l'amplitude, la deuxième caractéristique relative à l'amplitude et le produit interne; ou

pour calculer (27) le gain résiduel dans la sous-bande à l'aide d'un deuxième rapport impliquant la première caractéristique relative à l'amplitude, la deuxième caractéristique relative à l'amplitude et le produit interne, le deuxième rapport étant différent du premier rapport,

dans lequel la caractéristique relative à l'amplitude est déterminée à partir d'amplitudes, de puissances, d'énergies ou de toutes puissances d'amplitudes avec un exposant supérieur à 1.

10. Appareil selon la revendication 3, 5, 8 ou 9,

dans lequel le calculateur de paramètres (140) est configuré pour calculer, pour chaque sous-bande d'une pluralité de sous-bandes du premier canal et du deuxième canal, le gain latéral (141) ou le gain résiduel (142), ou

dans lequel le calculateur de paramètres est configuré pour calculer le gain latéral comme un gain de prédiction latéral qui est applicable à un signal central des premier et deuxième canaux pour prédire un signal de côté des premier et deuxième canaux, ou

dans lequel le calculateur de paramètres (140) est configuré pour calculer le gain résiduel comme un gain de prédiction résiduel indiquant une caractéristique relative à l'amplitude d'un signal résiduel d'une prédiction du signal de côté par le signal central à l'aide du gain latéral.

11. Appareil selon l'une des revendications 3, 5, 8 à 10,

dans lequel le calculateur de paramètres (140) est configuré pour calculer (26) le gain latéral à l'aide d'une fraction présentant un numérateur et un dénominateur, le numérateur impliquant une caractéristique relative à l'amplitude du premier canal et une caractéristique relative à l'amplitude du deuxième canal, et le dénominateur impliquant la caractéristique relative à l'amplitude du premier canal et la caractéristique relative à l'amplitude du deuxième canal et une valeur dérivée du produit interne, ou

dans lequel le calculateur de paramètres (140) est configuré pour calculer (27) le gain résiduel à l'aide d'une fraction présentant un numérateur et un dénominateur, le numérateur impliquant une valeur dérivée du produit interne et le dénominateur impliquant le produit interne.

12. Appareil selon la revendication 11,

dans lequel le calculateur de paramètres (140) est configuré pour calculer (26) le gain latéral, dans lequel le numérateur comprend une différence entre la première caractéristique relative à l'amplitude du premier canal et une deuxième caractéristique relative à l'amplitude du deuxième canal, et dans lequel le dénominateur comprend une somme de la première caractéristique relative à l'amplitude du premier canal et de la deuxième caractéristique relative à l'amplitude du deuxième canal et une valeur dérivée du produit interne, ou

dans lequel le calculateur de paramètres (140) est configuré pour calculer (27) le gain résiduel à l'aide de la fraction présentant le numérateur et le dénominateur, dans lequel le numérateur comprend une différence entre une somme pondérée de la première caractéristique relative à l'amplitude du premier canal et le deuxième caractéristique relative à l'amplitude du deuxième canal et une valeur dérivée du produit interne, et dans lequel le dénominateur comprend la somme de la caractéristique relative à l'amplitude du premier canal, la caractéristique relative à l'amplitude du deuxième canal et une valeur dérivée de le produit interne.

13. Appareil selon l'une des revendications 3, 5, 8 à 12,

dans lequel le calculateur de paramètres (140) est configuré pour calculer le gain latéral pour une sous-bande et pour calculer le gain résiduel pour la sous-bande (28) à l'aide du gain latéral pour la sous-bande.

14. Appareil selon l'une des revendications 3, 5, 8 à 12,

dans lequel le calculateur de paramètres (140) est configuré pour calculer le gain latéral de sorte que les valeurs du gain latéral se situent dans une plage de $\pm$ 20% des valeurs déterminées sur base de l'équation suivante:

$$g_{t,b} = \frac{E_{L,t,b} - E_{R,t,b}}{E_{L,t,b} + E_{R,t,b} + 2X_{L/R,t,b}},$$

*ou*

dans lequel le calculateur de paramètres (140) est configuré pour calculer le gain résiduel de sorte que les valeurs pour le gain résiduel se situent dans une plage de ± 20% de valeurs déterminées sur base de l'équation suivante:

$$r_{t,b} = (\frac{(1 - g_{t,b})E_{L,t,b} + (1 + g_{t,b})E_{R,t,b} + 2X_{\frac{L}{R},t,b}}{E_{L,t,b} + E_{R,t,b} + 2X_{L/R,t,b}})1/2,$$

où t est un indice de trame, où b est un indice de sous-bande, où $E_l$ est une énergie du canal gauche dans la trame et la sous-bande, où $E_R$ est une énergie du deuxième canal dans la trame t et la sous-bande b, et où X est le produit interne entre le premier canal et le deuxième canal dans la trame t et la sous-bande b.

**15.** Appareil selon l'une des revendications 3, 5, 8 à 14,
dans lequel le calculateur de paramètres (140) est configuré pour calculer une représentation par sous-bande du premier canal et du deuxième canal sous forme d'une séquence de spectres à valeurs complexes, dans lequel chaque spectre est relatif à une trame temporelle du premier ou du deuxième canal, dans lequel les trames temporelles de la séquence sont adjacentes dans la séquence de spectres et se chevauchent, ou dans lequel le calculateur de paramètres (140) est configuré pour calculer la première mesure relative à l'amplitude et la deuxième mesure relative à l'amplitude en élevant au carré les amplitudes des valeurs spectrales complexes dans une sous-bande et en additionnant les amplitudes au carré dans la sous-bande, ou
dans lequel le calculateur de paramètres (140) est configuré pour calculer un produit interne en additionnant, dans la sous-bande, les produits, dans lequel chaque produit implique une valeur spectrale dans un bin de fréquences du premier canal et une valeur spectrale complexe conjuguée du deuxième canal pour le bin de fréquences, et en formant une amplitude d'un résultat de l'addition.

**16.** Appareil selon l'une des revendications précédentes,
dans lequel l'interface de sortie (160) comprend un codeur de forme d'onde configuré pour coder en forme d'onde le signal de mélange vers le bas (122) pour obtenir les informations sur le signal de mélange vers le bas(122), ou
dans lequel le mélangeur vers le bas est configuré pour faire tourner le canal présentant l'énergie inférieure plus que le canal présentant l'énergie supérieure uniquement lorsque la différence d'énergie entre les canaux est supérieure à un seuil prédéfini.

**17.** Appareil pour mélanger vers le haut un signal multicanal codé (200), comprenant:

une interface d'entrée (204) destinée à recevoir le signal multicanal codé (200) et à obtenir un signal de mélange vers le bas (207) à partir du signal multicanal codé (200);
un mélangeur vers le haut (212) destiné à mélanger vers le haut le signal de mélange vers le bas (207), où le mélangeur vers le haut est configuré pour calculer un premier canal reconstruit (213) et un deuxième canal reconstruit (214) à l'aide d'une compensation de phase absolue, de sorte que le signal de mélange vers le bas soit, lors de la reconstruction d'un canal présentant une énergie inférieure parmi le premier canal reconstruit (213) et un deuxième canal reconstruit (214), uniquement tourné ou soit tourné plus fortement qu'un canal présentant une énergie supérieure parmi le premier canal reconstruit (213) et un deuxième canal reconstruit (214).

**18.** Appareil selon l'une des revendications 17,
dans lequel l'interface d'entrée (204) est configurée pour obtenir, à partir du signal multicanal codé (200), les valeurs de différence de phase entre canaux, et
dans lequel le mélangeur vers le haut (212) est configuré pour appliquer les valeurs de différence de phase entre canaux lors du calcul des premier et deuxième canaux reconstruits.

**19.** Appareil selon la revendication 18, dans lequel le mélangeur vers le haut (212) est configuré
pour calculer un paramètre de rotation de phase à partir d'une valeur de différence de phase entre canaux, et
pour appliquer le paramètre de rotation de phase lors du calcul du premier canal reconstruit d'une première manière et pour appliquer la valeur de différence de phase entre canaux et/ou le paramètre de rotation de phase lors du calcul du deuxième canal reconstruit d'une deuxième manière, où la première manière est différente de la deuxième manière.

**20.** Appareil selon la revendication 19,

dans lequel l'interface d'entrée (204) est configurée pour recevoir le signal multicanal codé (200) et pour obtenir un gain latéral (206) à partir du signal multicanal codé (200);

dans lequel le mélangeur vers le haut (212) est configuré pour calculer le paramètre de rotation de phase de sorte que le paramètre de rotation de phase absolue se situe dans une plage de ± 20% des valeurs déterminées par l'équation suivante:

$$ß = \text{atan}\left(sin\left(IPD_{t,b}\right), cos\left(IPD_{t,b}\right) + A\,\frac{1 + g_{t,b}}{1 - g_{t,b}}\right),$$

où atan est une fonction arc-tangente, où β est le paramètre de rotation de phase absolue, où IPD est la différence de phase entre canaux, où t est un indice de trame, b est un indice de sous-bande, et $g_{t,b}$ est le gain latéral pour la trame t et la sous-bande b, et où A est une valeur comprise entre 0,1 et 100 ou entre -0,1 et -100.

21. Appareil selon la revendication 20, dans lequel la fonction atan comprend une fonction atan2, la fonction atan2 (y, x) étant la fonction arc-tangente à deux arguments dont la valeur est l'angle entre le point (x, y) et l'axe x positif.

22. Appareil selon la revendication 20 ou 21,
dans lequel le mélangeur vers le haut (212) est configuré pour calculer le premier canal reconstruit et le deuxième canal reconstruit de sorte que le premier canal reconstruit et le deuxième canal reconstruit présentent des valeurs qui se situent dans la plage de ± 20% par rapport aux valeurs déterminées par les équations suivantes:

$$\tilde{L}_{t,k} = \frac{e^{\widetilde{iß}}\,\widetilde{M}_{t,k}}{\sqrt{2}}$$

et

$$\tilde{R}_{t,k} = \frac{e^{i(ß - \widetilde{IPD}_b)}\,\widetilde{M}_{t,k}}{\sqrt{2}}$$

où $\tilde{M}_{t,k}$ est le signal de mélange vers le bas pour la trame t et le bin de fréquences k.

23. Appareil selon la revendication 19 ou 20 ou 21,
dans lequel le mélangeur vers le haut (212) est configuré pour calculer le premier canal reconstruit et le deuxième canal reconstruit de sorte que le premier canal reconstruit et le deuxième canal reconstruit présentent des valeurs qui se situent dans la plage de ± 20% par rapport aux valeurs déterminées par les équations suivantes:

$$\tilde{L}_{t,k} = \frac{e^{\widetilde{iß}}\left(\widetilde{M}_{t,k}\left(1 + \tilde{g}_{t,b}\right) + \tilde{r}_{t,b}\,g_{norm}\,\tilde{\rho}_{t,k}\right)}{\sqrt{2}}$$

et

$$\tilde{R}_{t,k} = \frac{e^{i(ß - \widetilde{IPD}_b)}\left(\widetilde{M}_{t,k}\left(1 - \tilde{g}_{t,b}\right) - \tilde{r}_{t,b}\,g_{norm}\,\tilde{\rho}_{t,k}\right)}{\sqrt{2}}$$

où $\tilde{M}_{t,k}$ est le signal de mélange vers le bas pour la trame t et le bin de fréquences k, où $\tilde{g}_{t,b}$ est le gain latéral pour la trame t et la sous-bande b, où $\tilde{r}_{t,b}$ est un gain résiduel pour la trame t et la sous-bande b, où $g_{norm}$ est un facteur de réglage d'énergie qui peut être présent ou non, et où $\tilde{\rho}_{t,k}$ est un signal résiduel brut pour la trame t et le bin de fréquences k.

**24.** Appareil selon l'une quelconque des revendications 17 à 23,
dans lequel l'interface d'entrée (204) est configurée pour recevoir le signal multicanal codé (200) et pour obtenir un gain latéral (206) et un gain résiduel (205) à partir du signal multicanal codé (200);
dans lequel l'appareil comprend par ailleurs un synthétiseur de signal résiduel (208) destiné à synthétiser un signal résiduel (209) à l'aide du gain résiduel (205);
dans lequel le mélangeur vers le haut (212) est configuré pour effectuer une première opération de pondération (70) du signal de mélange vers le bas (207) à l'aide du gain latéral (206) pour obtenir un premier signal de mélange vers le bas pondéré (76),
dans lequel le mélangeur vers le haut (212) est configuré pour effectuer une deuxième opération de pondération (71) à l'aide du gain latéral (206) et du signal de mélange vers le bas (207) pour obtenir un deuxième signal de mélange vers le bas pondéré (77),
dans lequel la première opération de pondération (70) est différente de la deuxième opération de pondération (71), de sorte que le premier signal de mélange vers le bas pondéré (76) soit différent du deuxième signal de mélange vers le bas pondéré (77), et
dans lequel le mélangeur vers le haut (212) est configuré pour calculer le premier canal reconstruit à l'aide d'une combinaison (72) du premier signal de mélange vers le bas pondéré (76) et du signal résiduel (209) et à l'aide d'une deuxième combinaison (73) du deuxième signal de mélange vers le bas pondéré (77) et du signal résiduel (209).

**25.** Appareil selon la revendication 24,
dans lequel le mélangeur vers le haut (212) est configuré pour combiner (72) le signal de mélange vers le bas pondéré (76) et le signal résiduel (209) lors du calcul du premier canal reconstruit, et
dans lequel le mélangeur vers le haut (212) est configuré pour combiner (73) le deuxième signal de mélange vers le bas pondéré (77) et le signal résiduel (209) à l'aide d'une deuxième règle de combinaison (73) lors du calcul du deuxième canal reconstruit, où la première règle de combinaison (72) et la deuxième règle de combinaison (73) sont différentes l'une de l'autre, ou
dans lequel l'une des première et deuxième règles de combinaison (72, 73) est une opération d'addition et l'autre des première et deuxième règles de combinaison est une opération de soustraction.

**26.** Appareil selon l'une des revendications 23 à 25,
dans lequel le mélangeur vers le haut (212) est configuré pour effectuer la première opération de pondération (70) comprenant un facteur de pondération dérivé d'une somme du gain latéral et du premier nombre prédéterminé, et
dans lequel le mélangeur vers le haut (212) est configuré pour effectuer la deuxième opération de pondération (71) comprenant un facteur de pondération dérivé d'une différence entre un deuxième nombre prédéterminé et le gain latéral, où les premier et deuxième nombres prédéterminés sont égaux l'un à l'autre ou sont différents l'un de l'autre.

**27.** Appareil selon l'une des revendications 23 à 26,
dans lequel le synthétiseur de signal résiduel (208) est configuré pour pondérer un signal de mélange vers le bas (207) d'une trame précédente à l'aide du gain résiduel (209) pour une trame actuelle pour obtenir le signal résiduel (209) pour la trame actuelle, ou
pour pondérer (88) un signal décorrélé dérivé (80) de la trame actuelle ou d'une ou plusieurs trames précédentes à l'aide du gain résiduel (205) pour la trame actuelle pour obtenir le signal résiduel (209) pour la trame actuelle.

**28.** Appareil selon l'une des revendications 23 à 27,
dans lequel le calculateur de signal résiduel (208) est configuré pour calculer le signal résiduel (209) de sorte qu'une énergie du signal résiduel (209) soit égale à une énergie de signal indiquée par le gain résiduel (205).

**29.** Appareil selon l'une des revendications 23 à 28,
dans lequel le calculateur de signal résiduel (208) est configuré pour calculer le signal résiduel de sorte que les valeurs du signal résiduel se situent dans une plage de $\pm$ 20% des valeurs déterminées sur base de l'équation suivante:

$$\tilde{R}_{t,k} = \frac{\tilde{r}_{t,b} g_{norm} \tilde{\rho}_{t,k}}{\sqrt{2}}$$

où $R_{t,k}$ est le signal résiduel pour la trame t et le bin de fréquences k, où $\tilde{r}_{t,b}$ est le gain résiduel pour la trame t et la sous-bande b comprenant le bin de fréquences k, et où $\tilde{\rho}_{t,k}$ est un signal résiduel, et où $g_{norm}$ est un facteur de réglage d'énergie qui peut être présent ou non.

**30.** Appareil selon l'une des revendications 23 à 29,
dans lequel $g_{norm}$ est un facteur de normalisation d'énergie présentant des valeurs situées dans la plage de $\pm$ 20% des valeurs déterminées par l'équation suivante:

$$\sqrt{\frac{E_{\tilde{M},t,b}}{E_{\tilde{\rho},t,b}}},$$

où $E_{\tilde{M},t,b}$ est l'énergie du signal de mélange vers le bas pour la trame t et la sous-bande b, et où $E_{\tilde{\rho},t,b}$ est l'énergie du signal résiduel pour la sous-bande b et la trame t, ou
dans lequel un signal brut pour le signal résiduel est déterminé sur base de l'équation suivante:

$$\tilde{\rho}_{t,k} = \tilde{M}_{t-d_b,k},$$

où $\tilde{\rho}_{t,k}$ est le signal brut du signal résiduel,
où $\tilde{M}_{t-d_b,k}$ est le signal de mélange vers le bas pour la trame t - $t_b$ et le bin de fréquences k, où $d_b$ est un retard de trame supérieur à 0, ou

dans lequel le mélangeur vers le haut (212) est configuré pour calculer le premier canal reconstruit et le deuxième canal reconstruit de sorte que le premier canal reconstruit et le deuxième canal reconstruit présentent des valeurs qui se situent dans la plage de $\pm$ 20% par rapport aux valeurs déterminées par les équations suivantes:

$$\tilde{L}_{t,k} = \frac{e^{i\ss}\left(\tilde{M}_{t,k}\left(1+\tilde{g}_{t,b}\right)+\tilde{r}_{t,b}g_{norm}\tilde{\rho}_{t,k}\right)}{\sqrt{2}}$$

et

$$\tilde{R}_{t,k} = \frac{e^{i(\ss-\widetilde{IPD}_b)}\left(\tilde{M}_{t,k}\left(1-\tilde{g}_{t,b}\right)-\tilde{r}_{t,b}g_{norm}\tilde{\rho}_{t,k}\right)}{\sqrt{2}}$$

où $\tilde{M}_{t,k}$ est le signal de mélange vers le bas pour la trame t et le bin de fréquences k, où $\tilde{g}_{t,b}$ est le gain latéral pour la trame t et la sous-bande b, où $\tilde{r}_{t,b}$ est le gain résiduel pour la trame t et la sous-bande b, où $g_{norm}$ est un facteur de réglage d'énergie qui peut être présent ou non, et où $\tilde{\rho}_{t,k}$ est un signal résiduel brut pour la trame t et le bin de fréquences k.

**31.** Appareil selon l'une des revendications 17 à 30,
dans lequel le mélangeur vers le haut (212) est configuré pour calculer le premier canal reconstruit (213) et le deuxième canal reconstruit (214) dans un domaine spectral,
dans lequel l'appareil comprend par ailleurs un convertisseur spectre-temps (216) destiné à convertir le premier canal reconstruit et le deuxième canal reconstruit à un domaine temporel,
dans lequel le mélangeur vers le haut est configuré pour faire tourner le canal présentant l'énergie inférieure plus que le canal présentant l'énergie supérieure uniquement lorsque la différence d'énergie entre les canaux est supérieure à un seuil prédéfini.

**32.** Appareil selon la revendication 31,
dans lequel le convertisseur spectre-temps (216) est configuré pour (301) convertir, pour chacun des premier et deuxième canaux reconstruits, les trames suivantes en une séquence temporelle de trames,
pour pondérer (1312) chaque trame temporelle à l'aide d'une fenêtre de synthèse; et
pour effectuer une opération de chevauchement et d'addition (1314) des trames temporelles divisées en fenêtres suivantes pour obtenir un bloc temporel du premier canal reconstruit (217) et le bloc temporel du deuxième canal reconstruit 218.

**33.** Procédé de mélange vers le bas d'un signal multicanal (100) comprenant au moins deux canaux (101, 102), comprenant le fait de:

calculer (34) un signal de mélange vers le bas (122) à partir du signal multicanal (100), où le calcul comprend le fait de calculer le mélange vers le bas à l'aide d'une compensation de phase absolue, de sorte qu'un canal présentant une énergie plus faible parmi les au moins deux canaux soit uniquement tourné ou soit tourné plus fortement qu'un canal présentant une plus grande énergie lors du calcul du signal de mélange vers le bas (122); et générer (160) un signal de sortie, le signal de sortie comprenant les informations sur le signal de mélange vers le bas (122).

**34.** Procédé de mélange vers le haut d'un signal multicanal codé (200), comprenant le fait de:

recevoir (204) le signal multicanal codé (200) pour obtenir un signal de mélange vers le bas (207) à partir du signal multicanal codé (200); mélanger vers le haut (212) le signal de mélange vers le bas (207), le mélange vers le haut comprenant le fait de calculer un premier canal reconstruit (213) et un deuxième canal reconstruit (214) à l'aide d'une compensation de phase absolue, de sorte que le signal de mélange vers le bas soit, lors de la reconstruction d'un canal présentant une énergie inférieure parmi le premier canal reconstruit (213) et un deuxième canal reconstruit (214), uniquement tourné ou soit tourné plus fortement qu'un canal présentant une énergie plus grande parmi le premier canal reconstruit (213) et un deuxième canal reconstruit (214).

**35.** Programme d'ordinateur pour réaliser, lorsqu'il est exécuté sur l'ordinateur ou un processeur, le procédé selon la revendication 33 ou le procédé selon la revendication 34.

Fig. 1

EP 3 539 126 B1

Fig. 2

Fig. 3

Fig. 4

EP 3 539 126 B1

Fig. 5a

sign bit

point
ID

57b

57a

group
ID

57c

code for
g, r for a
subband

Fig. 5b

Fig. 6

EP 3 539 126 B1

Fig. 7

Fig. 8

Fig. 9

EP 3 539 126 B1

Fig. 10a

Fig. 10b

Fig. 10c

213, 214 ─→ **1310** backward transformer ─→ **1312** synthesis windower ─→ **1314** overlap/ adder ─→ 217, 218 time domain channels

Fig. 10d

lines for joint quantization
energy lines

residual gain

side gain

Fig. 11

EP 3 539 126 B1

Fig. 12

Fig. 13

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 20080253576 A1

**Non-patent literature cited in the description**

- FROM JOINT STEREO TO SPATIAL AUDIO CODING - RECENT PROGRESS AND STANDARDIZATION. *Proc. of the 7th Int. Conference on digital Audio Effects (DAFX-04),* 05 October 2004